# EUROPEAN PATENT APPLICATION

(11) **EP 4 554 362 A1**
(43) Date of publication of application: **14.05.2025**
(21) Application number: 24210607.8
(22) Date of filing: 04.11.2024
(51) Int. Cl.: H10K 59/131, H10K 59/82, G02F 1/1345

(54) **DISPLAY DEVICE, ELECTRONIC DEVICE, AND METHOD OF MANUFACTURING THE DISPLAY DEVICE**

(30) Priority: 13.11.2023 KR 20230156041
(71) Applicant: Samsung Display Co., Ltd., Gyeonggi-Do (KR)
(72) Inventor: KIM, Daesoo, Yongin-si (KR); KIM, Sanggab, Yongin-si (KR); PARK, Taesang, Yongin-si (KR); SEO, Dongkyun, Yongin-si (KR); JUNG, Yang-Ho, Yongin-si (KR); CHOI, Daewon, Yongin-si (KR)
(74) Representative: Marks & Clerk LLP

(57) **Abstract**

A display device includes a display panel displaying an image, a circuit board coupled with the display panel, and a metal pattern electrically connecting the display panel and the circuit board. The display panel includes a base layer and a circuit layer disposed on the base layer and including a pad electrode exposed to an outside via an opening defined through the base layer. The metal pattern includes a first portion overlapping the opening and being in contact with the pad electrode and a second portion that does not overlap the opening and is in contact with the circuit board.

## Description

### BACKGROUND

### 1. Field

The present invention relates to a display device, an electronic device, and a method of manufacturing the display device, and more particularly, to a display device including a circuit board capable of being bonded to a rear surface thereof, an electronic device, and a method of manufacturing the display device.

### 2. Description of Related Art

Electronic devices, such as smartphones, tablet computers, notebook computers, car navigation units, and smart televisions, are being developed. The electronic devices include a display device to provide information.

Various types of display devices are being developed to satisfy the user experience (UX) and the user interface (UI).

### SUMMARY

The present invention provides a display device manufactured by a simplified manufacturing method and provided with a reduced non-display area.

The present invention provides an electronic device including the display device.

The present invention provides a method of manufacturing the display device.

According to an embodiment, the invention provides a display device including a display panel displaying (e.g. configured to display) an image, a circuit board coupled with the display panel, and a metal pattern electrically connecting the display panel and the circuit board. The display panel includes a base layer and a circuit layer disposed on the base layer and including a pad electrode exposed to an outside via a first opening defined through the base layer. The metal pattern includes a first portion overlapping the first opening and being in contact with the pad electrode and a second portion that does not overlap the first opening and is in contact with the circuit board.

In an embodiment, the pad electrode may include a first pad portion that is disposed on the base layer and does not overlap the first opening and a second pad portion overlapping the first opening.

In an embodiment, the base layer may include a sub-base layer that is in contact with the circuit board and a base inorganic layer disposed on the sub-base layer.

In an embodiment, the first opening may include a first sub-opening defined through the base inorganic layer and a second sub-opening defined through the sub-base layer.

In an embodiment, the second pad portion may be disposed in the first sub-opening, and the second pad portion may be exposed to the outside via the second sub-opening.

In an embodiment, the circuit layer may include an inorganic layer disposed on the base layer, the pad electrode may be disposed on the inorganic layer, and the inorganic layer may include a second opening through which the pad electrode is exposed to correspond to the first opening.

In an embodiment, the circuit layer may include a transistor, at least one signal line connected to the transistor, and a shielding electrode disposed under the transistor and overlapping a semiconductor pattern of the transistor.

In an embodiment, the first pad portion and the shielding electrode may be disposed on a same layer.

In an embodiment, the circuit layer may further include a connection pattern connected to the semiconductor pattern, and the first pad portion and the connection pattern are disposed on a same layer.

In an embodiment, the transistor may further include a gate electrode overlapping the semiconductor pattern, and the first pad portion and the gate electrode are disposed on a same layer.

In an embodiment, the circuit layer may further include at least one signal line connected to the transistor, and the pad electrode is electrically connected to the signal line.

In an embodiment, the first portion may be disposed in the first opening.

In an embodiment, the first portion may cover one side surface of the base layer that defines the first opening.

In an embodiment, the display device may further include an adhesive resin of which at least a portion is disposed in the first opening, and the adhesive resin covers the metal pattern.

In an embodiment, the adhesive resin may cover the other side surface of the base layer, which faces the one side surface of the base layer.

In an embodiment, the metal pattern and the adhesive resin may be disposed to fill the first opening.

In an embodiment, the circuit board may include a base film and a bump electrode disposed between the base film and the base layer, and the bump electrode is electrically connected to the pad electrode via the metal pattern.

In an embodiment, each of the bump electrode and the pad electrode may be provided in plural, and the metal pattern may be provided in plural to correspond to the bump electrodes and the pad electrodes.

In an embodiment, the display device may further include an adhesive layer disposed between the bump electrode and the base layer.

In an embodiment, the circuit board may be disposed to be spaced apart from the first opening.

Embodiments of the invention provide an electronic device including a housing, an electronic module disposed in the housing, and a display device disposed to overlap the electronic module. The display device includes a display panel displaying (e.g. configured to display) an image, a circuit board coupled with the display panel, and a metal pattern electrically connecting the display panel and the circuit board. The display panel includes a base layer and a circuit layer disposed on the base layer and including a pad electrode exposed to an outside via a first opening defined through the base layer. The metal pattern includes a first portion overlapping the first opening and being in contact with the pad electrode and a second portion that does not overlap the first opening and is in contact with the circuit board.

Embodiments of the invention provide a method of manufacturing a display device. The manufacturing method of the display device includes forming a preliminary base layer, placing a pad electrode on the preliminary base layer to form a circuit layer, etching the preliminary base layer to form a base layer through which a first opening is defined to expose the pad electrode to an outside, placing a circuit board on a lower surface of the base layer, and forming a metal pattern to electrically connect the pad electrode and the circuit board. The metal pattern includes a first portion overlapping the first opening and being in contact with the pad electrode and a second portion that does not overlap the first opening and being in contact with the circuit board.

In an embodiment, the forming of the preliminary base layer may include forming a first preliminary sub-base layer, forming a first preliminary base inorganic layer on the first preliminary sub-base layer, forming a second preliminary sub-base layer on the first preliminary base inorganic layer, and forming a second preliminary base inorganic layer on the second preliminary sub-base layer.

In an embodiment, the forming of the preliminary base layer may further include first preliminary-etching the first preliminary base inorganic layer to form a first base inorganic layer before the forming of the second preliminary sub-base layer and second preliminary-etching the second preliminary base inorganic layer to form a second base inorganic layer before the placing of the pad electrode on the preliminary base layer.

In an embodiment, the placing of the pad electrode on the preliminary base layer may include placing the pad electrode in a sub-opening formed through the second base inorganic layer by the second preliminary-etching.

In an embodiment, the forming of the circuit layer may further include placing an inorganic layer on the preliminary base layer, and the pad electrode is disposed on the inorganic layer.

In an embodiment, the forming of the base layer may further include etching the preliminary base layer to form the first opening and etching the inorganic layer to form a second opening through which the pad electrode is exposed to the outside to correspond to the first opening.

In an embodiment, the second opening may be substantially simultaneously formed with the first opening.

In an embodiment, the forming of the circuit layer may further include forming a metal layer on the inorganic layer and etching the metal layer to form the pad electrode.

In an embodiment, the forming of the circuit layer may further include forming a shielding electrode and forming a transistor including a semiconductor pattern on the shielding electrode, and the semiconductor pattern may overlap the shielding electrode.

In an embodiment, the pad electrode may be substantially simultaneously formed with the shielding electrode of the transistor.

In an embodiment, the forming of the circuit layer may further include forming a gate electrode overlapping the semiconductor pattern, and the pad electrode is substantially simultaneously formed with the gate electrode.

In an embodiment, the forming of the circuit layer may further include forming a connection pattern connected to the semiconductor pattern, and the pad electrode is substantially simultaneously formed with the connection pattern.

In an embodiment, the method may further include forming an adhesive resin of which at least a portion is disposed in the first opening after the forming of the metal pattern, and the adhesive resin covers the metal pattern.

At least some of the above and other features of the invention are set out in the claims.

According to an embodiment, a flexible circuit board is coupled to the display panel on a rear surface of the display panel (rear-surface bonding). A non-display area of the display panel is not bent, and thus, defects occurring when the non-display area of the display panel is bent are prevented. In addition, a bezel area of a window covering the non-display panel of the display panel is reduced.

According to an embodiment, the manufacturing method of the display device includes forming of a base opening that is formed to completely penetrate the base layer and expose the pad electrode embedded in the circuit layer to the outside. The metal patterns disposed in the base opening defined to completely penetrate the base layer electrically connect the pad electrodes and the bump electrodes. As the metal patterns are directly connected to the pad electrodes exposed through the base opening, a connection electrode is not required between the pad electrodes and the metal patterns. Accordingly, a manufacturing process of the display device is simplified.

### BRIEF DESCRIPTION OF THE DRAWINGS

The above and other advantages of the invention will become readily apparent by reference to the following detailed description when considered in conjunction with the accompanying drawings wherein:
FIG. 1 is a perspective view of an electronic device, according to an embodiment;
FIG. 2 is an exploded perspective view of an electronic device, according to an embodiment;
FIG. 3 is a cross-sectional view of a display device taken along a line I-I' of FIG. 2, according to an embodiment;
FIG. 4 is a cross-sectional view of a display module, according to an embodiment;
FIG. 5 is a plan view of a display panel, according to an embodiment;
FIG. 6 is a cross-sectional view of a display module, according to an embodiment;
FIG. 7 is a plan view of a display panel, according to an embodiment;
FIG. 8 is an enlarged plan view of a portion of a display device, according to an embodiment;
FIG. 9A is a cross-sectional view of a portion of a display device taken along a line II-II' of FIG. 8, according to an embodiment;
FIG. 9B is a cross-sectional view of a portion of a display device according to an embodiment;
FIG. 10A is a cross-sectional view of a portion of a display device, according to an embodiment;
FIG. 10B is a cross-sectional view of a portion of a display device, according to an embodiment;
FIG. 11 is a flowchart illustrating a method of manufacturing a display device, according to an embodiment;
FIG. 12A is a view illustrating a process of a method of manufacturing a display device, according to an embodiment;
FIG. 12B is a view illustrating a process of a method of manufacturing a display device, according to an embodiment;
FIG. 12C is a view illustrating a process of a method of manufacturing a display device, according to an embodiment;
FIG. 12D is a view illustrating a process of a method of manufacturing a display device, according to an embodiment;
FIG. 12E is a view illustrating a process of a method of manufacturing a display device, according to an embodiment;
FIG. 12F is a view illustrating a process of a method of manufacturing a display device, according to an embodiment;
FIG. 12G is a view illustrating a process of a method of manufacturing a display device, according to an embodiment;
FIG. 12H is a view illustrating a process of a method of manufacturing a display device, according to an embodiment;
FIG. 12I is a view illustrating a process of a method of manufacturing a display device, according to an embodiment;
FIG. 13A is a flowchart illustrating a method of manufacturing a display device, according to an embodiment;
FIG. 13B is a flowchart illustrating a method of manufacturing a display device, according to an embodiment; and
FIG. 13C is a flowchart illustrating a method of manufacturing a display device, according to an embodiment.

### DETAILED DESCRIPTION

The invention may be variously modified and realized in many different forms, and thus specific embodiments will be exemplified in the drawings and described in detail hereinbelow. However, the invention should not be limited to the specific disclosed embodiments, and should be construed to include all modifications, equivalents, or replacements included in the scope of the invention.

In the present disclosure, it will be understood that when an element (or area, layer, or portion) is referred to as being "on", "connected to" or "coupled to" another element or layer, it can be directly on, connected or coupled to the other element or layer or intervening elements or layers may be present.

Like numerals refer to like elements throughout. In the drawings, the thickness, ratio, and dimension of components are exaggerated for effective description of the technical content.

As used herein, the term "and/or" may include any and all combinations of one or more of the associated listed items.

It will be understood that, although the terms first, second, etc. may be used herein to describe various elements, these elements should not be limited by these terms. These terms are only used to distinguish one element from another element. Thus, a first element discussed below could be termed a second element without departing from the teachings of the present disclosure. As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to other elements or features as shown in the figures.

Unless otherwise defined, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

Hereinafter, embodiments of the invention will be described with reference to the accompanying drawings.

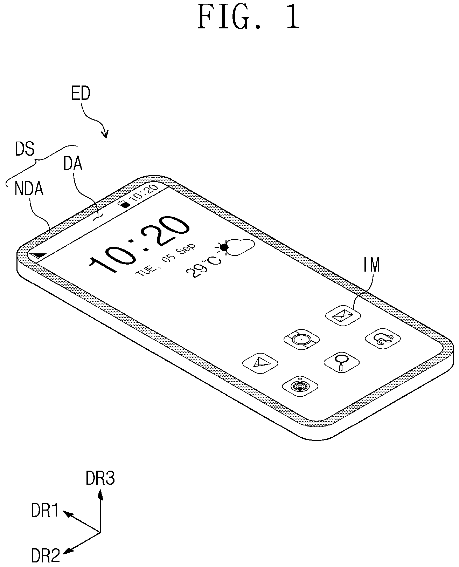

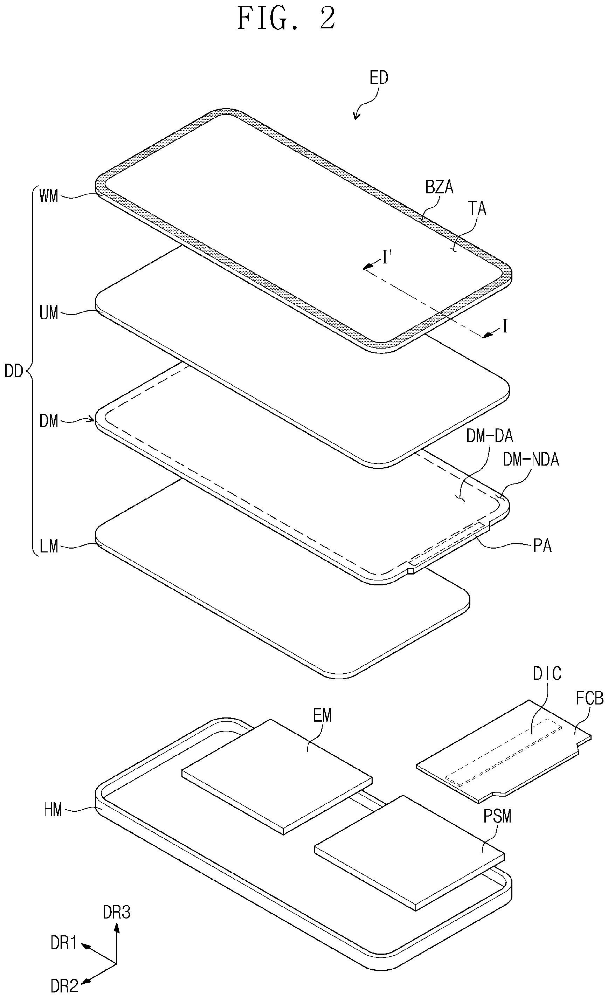

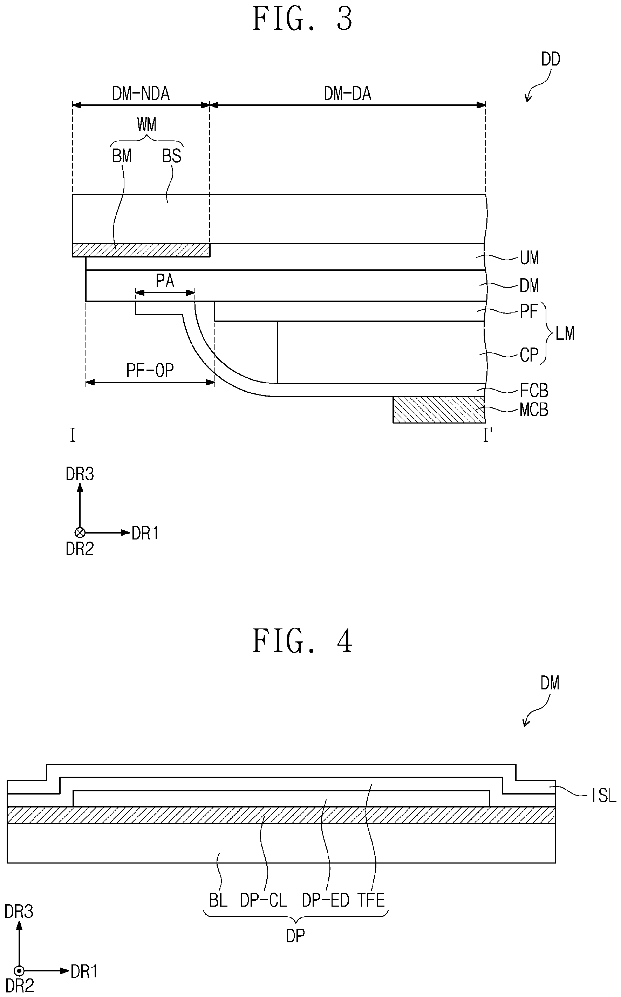

FIG. 1 is a perspective view of an electronic device ED, according to an embodiment. FIG. 2 is an exploded perspective view of the electronic device ED, according to an embodiment. FIG. 3 is a cross-sectional view of a display device DD taken along a line I-I' of FIG. 2, according to an embodiment.

In an embodiment and referring to FIG. 1, the electronic device ED may include a display surface DS defined by a first direction DR1 and a second direction DR2 intersecting the first direction DR1. The electronic device ED may provide an image IM to a user through the display surface DS.

In an embodiment, the display surface DS may include a display area DA and a non-display area NDA disposed around the display area DA. The display area DA may display the image IM, and the non-display area NDA may not display the image IM. The non-display area NDA may surround the display area DA, however, it should not be limited thereto or thereby, and the shape of the display area DA and the shape of the non-display area NDA may be changed.

Hereinafter, a direction that is substantially perpendicular to the plane defined by the first direction DR1 and the second direction DR2 may be referred to as a third direction DR3. Front and rear surfaces of each member of the electronic device ED may be distinguished from each other with respect to the third direction DR3. In the present disclosure, the expression "when viewed in a plane" may mean a state of being viewed in the third direction DR3.

In an embodiment, the electronic device ED may be a foldable electronic device folded with respect to a folding axis. The folding axis may be substantially parallel to the first direction DR1 or the second direction DR2, and a folding area may be defined in a portion of the display area DA. The electronic device ED may be inwardly folded (inner-folding) to allow a portion of the display area DA to face the other portion of the display area DA or may be outwardly folded (outer-folding) to allow the portion of the display area DA not to face the other portion of the display area DA.

In an embodiment and referring to FIG. 2, the electronic device ED may include the display device DD, an electronic module EM, a power source module PSM, and a housing HM. The electronic device ED is schematically shown in FIG. 2, and the electronic device ED may further include a mechanical structure (e.g., a hinge) to control an operation, for example, a folding or rolling operation, of the display device DD.

In an embodiment, the display device DD may generate the image IM and may sense an external input. The display device DD may include a window WM, an upper member UM, a display module DM, a lower member LM, a circuit board (or a flexible circuit board) FCB, and a driving chip DIC. The upper member UM may include components disposed above the display module DM, and the lower member LM may include components disposed below the display module DM.

In an embodiment, the window WM may provide a front surface of the electronic device ED. The window WM may include a transmission area TA and a bezel area BZA. The display area DA and the non-display area NDA of the display surface DS shown in FIG. 1 may be defined by the transmission area TA and the bezel area BZA. The transmission area TA may be an area through which the image passes, and the bezel area BZA may be an area that covers structures/members disposed under the window WM.

In an embodiment, the display module DM may include a display area DM-DA and a non-display area DM-NDA, which respectively correspond to the display area DA and the non-display area NDA shown in FIG. 1. In the present disclosure, the expression "An area/portion corresponds to another area/portion." means that "An area/portion overlaps another area/portion.", however, they should not be limited to having the same size as each other.

In an embodiment, a pad area PA may be defined at one side of the non-display area DM-NDA. The pad area PA may be electrically bonded or connected to the circuit board FCB described later. In an embodiment, the pad area PA may be defined in a rear surface of the display module DM.

In an embodiment, the display module DM may have a substantially quadrangular shape. The expression "a substantially quadrangular shape" used herein may mean not only the mathematical concept of a rectangular shape, but also shapes that are similar to rectangles and perceived by the user as rectangles. For instance, the substantially quadrangular shape may include a quadrangular shape with a rounded corner. In addition an edge of the display module DM having the substantially rectangular shape should not be limited to a straight line, and the edge may have a curved area.

In an embodiment, the upper member UM may include a protective film or an optical film. The optical film may include a polarizer or a retarder to reduce a reflection of an external light. The lower member LM may include a protective film protecting the display module DM, a support member supporting the display module DM, and a digitizer. The upper member UM and the lower member LM will be described in detail later.

In an embodiment, the circuit board FCB may be disposed under the display module DM. The circuit board FCB may be bonded to a rear surface of the display module DM and may electrically connect the display module DM to a main circuit board MCB (refer to FIG. 3). The circuit board FCB may include at least one insulating layer and at least one conductive layer. The conductive layer may include a plurality of signal lines.

In an embodiment, the driving chip DIC may be mounted on the circuit board FCB. The driving chip DIC may include a driving circuit, e.g., a data driving circuit, to drive pixels of the display module DM. FIG. 2 shows a structure in which the driving chip DIC is mounted on the circuit board FCB, however, the invention should not be limited thereto or thereby. As an example, in another embodiment, the driving chip DIC may be mounted on the display module DM or the main circuit board MCB (See FIG. 3).

In an embodiment, the electronic module EM may include a control module, a wireless communication module, an image input module, an audio input module, an audio output module, a memory, and an external interface module. The electronic module EM may include the main circuit board, and the modules may be mounted on the main circuit board or may be electrically connected to the main circuit board via a flexible circuit board. The electronic module EM may be electrically connected to the power source module PSM.

In an embodiment, although not shown in the figures, the electronic device ED may further include an electro-optical module. The electro-optical module may be an electronic component that outputs or receives an optical signal. The electro-optical module may include a camera module and/or a proximity sensor. The camera module may take a picture of an external object via an area of the display module DM.

In an embodiment, the housing HM shown in FIG. 2 may be coupled to the display device DD, particularly, the window WM to accommodate the above-mentioned modules. The housing HM is shown as having an integral shape, however, it should not be limited thereto or thereby. In an embodiment, the housing HM may include a plurality of portions, for instance, a side surface edge portion and a bottom portion, coupled to each other.

In an embodiment and referring to FIG. 3, the window WM may include a base substrate BS and a bezel pattern BM disposed on a lower surface of the base substrate BS. In an embodiment, the base substrate BS may include a synthetic resin film or a glass substrate. The base substrate BS may have a multi-layer structure. The base substrate BS may include a thin glass substrate, a protective film disposed on the thin glass substrate, and an adhesive layer that attaches the thin glass substrate and the protective film.

In an embodiment, the bezel pattern BM may be a colored light blocking layer and may be formed by a coating process. The bezel pattern BM may include a base material and a pigment or dye mixed with the base material. The bezel pattern BM may overlap the non-display area NDA shown in FIG. 1 and the bezel area BZA shown in FIG. 2. The bezel pattern BM may be disposed on the lower surface of the base substrate BS. When the base substrate BS has a multi-layer structure, the bezel pattern BM may be disposed at an interface defined between plural layers. For instance, in an embodiment, the bezel pattern BM may be disposed between the thin glass substrate and the protective film. Although not shown in figures, in an embodiment, the window WM may include at least one of a hard coating layer, an anti-fingerprint layer, and an anti-reflective layer disposed on an upper surface of the base substrate BS.

In an embodiment, the upper member UM may include an upper film. The upper film may include a synthetic resin film. The synthetic resin film may include polyimide, polycarbonate, polyamide, triacetyl cellulose, polymethylmethacrylate, or polyethylene terephthalate.

In an embodiment, the upper film may absorb an external impact applied to a front surface of the display device DD. According to an embodiment, the display module DM may include a color filter as an anti-reflective member to replace a polarizing film, and in this case, an impact resistance of the display device DD with respect to external impacts applied to the front surface thereof may be reduced. The upper film may compensate for the reduction of the impact resistance with respect to the external impacts, which is caused by applying the color filter to the display module DM.

In an embodiment, the upper member UM may overlap the bezel area BZA (refer to FIG. 2) and the transmission area TA (refer to FIG. 2). The upper member UM may overlap only a portion of the bezel area BZA. A portion of the bezel pattern BM may be exposed without being covered by the upper member UM. According to an embodiment, the upper member UM may be omitted. According to an embodiment, the upper member UM may be replaced with the optical film including the polarizer and the retarder.

In an embodiment, although not shown in the figures, an adhesive layer attaching the upper member UM and the window WM may be disposed between the upper member UM and the window WM. The adhesive layer may be a pressure sensitive adhesive (PSA) film or an optically clear adhesive (OCA).

In an embodiment, the display module DM may be disposed under the upper member UM. The display module DM may overlap the bezel area BZA and the transmission area TA. The display module DM may completely overlap the upper member UM in the bezel area BZA. A side surface of the display module DM may be aligned with a side surface of the upper member UM, and a corner of the display module DM may be aligned with a corner of the upper member UM when viewed in the plane.

In an embodiment, in the bezel area BZA, the pad area PA of the display module DM may overlap the upper member UM. A portion of the display module DM, which corresponds to the pad area PA, may be coupled with a lower surface of the upper member UM by an adhesive layer. As the pad area PA overlaps the upper member UM and the portion of the display module DM overlapping the pad area PA is coupled with the upper member UM, the upper member UM may sufficiently support the pad area PA when the circuit board FCB is bonded to the pad area PA.

In an embodiment, the lower member LM may include a lower film PF and a cover panel CP. The lower member LM may further include a support plate and a digitizer.

In an embodiment, the lower film PF may expose the pad area PA of the display module DM. The lower film PF may have an area smaller than that of the display module DM. For instance, the lower film PF may overlap only the display area DM-DA. The lower film PF may be provided with an opening area PF-OP defined therein to correspond to the non-display area DM-NDA. In another embodiment, the lower film PF may have substantially the same size as the display module DM. In this case, the lower film PF may be provided with an opening area PF-OP defined therein to correspond to the pad area PA. The pad area PA may be exposed through the opening area PF-OP.

In an embodiment, the lower film PF may expose the pad area PA. The lower film PF may have an area smaller than that of the display module DM. For instance, the lower film PF may overlap only the display area DA. The lower film PF may have substantially the same size as the display module DM. The lower film PF may be provided with an opening area PF-OP defined therein to correspond to the pad area PA. The pad area PA may be exposed through the opening area PF-OP.

In an embodiment, the cover panel CP may be disposed under the lower film PF. The cover panel CP may increase a resistance against a compressive force caused by external pressure force. Accordingly, the cover panel CP may prevent the display module DM from being deformed. The cover panel CP may include a flexible plastic material, such as polyimide or polyethylene terephthalate. In addition, the cover panel CP may be a colored film with low light transmittance. The cover panel CP may absorb a light incident thereto from the outside. As an example, the cover panel CP may be a black synthetic resin film. When looking at the display device DD from an upper side of the window WM, components disposed under the cover panel CP may not be viewed by the user.

In an embodiment, although not shown in the figures, the support plate may be further disposed under the cover panel CP. The support plate may include a high-strength metal material. The support plate may include a reinforced fiber composite material. The support plate may include a reinforced fiber disposed in a matrix portion. The reinforced fiber may be a carbon fiber or a glass fiber. The matrix portion may include a polymer resin. The matrix portion may include a thermoplastic resin. As an example, in an embodiment, the matrix portion may include a polyamide-based resin or a polypropylene-based resin. For example, in an embodiment, the reinforced fiber composite material may be a carbon fiber reinforced plastic (CFRP) or a glass fiber reinforced plastic (GFRP).

In an embodiment, the main circuit board MCB may be disposed on a lower surface of the circuit board FCB. The circuit board FCB may include an insulating film and conductive lines mounted on the insulating film. The main circuit board MCB may include signal lines (not shown) and electronic elements (not shown). The electronic elements may be connected to the signal lines and may be electrically connected to the display module DM. The electronic elements may generate various electrical signals, e.g., a signal to generate images or a signal to sense the external input, or may process the sensed signal. Meanwhile, the main circuit board MCB may be provided to correspond to each of the electrical signals to be generated and processed, and three or more main circuit boards MCB may be provided.

In an embodiment, although not shown in the figures, the main circuit board MCB may include the driving chip DIC (refer to FIG. 2) mounted therein.

In an embodiment and referring to FIGS. 2 and 3, the circuit board FCB may be coupled with the rear surface of the display module DM (a rear-surface bonding). Since the non-display area DM-NDA of the display module DM is not bent, defects occurring when the display module DM is bent may be prevented in the non-display area DM-NDA. In addition, a size of the bezel area BZA of the window WM, which is required to cover the non-display area DM-NDA of the display module DM, may be reduced.

FIG. 4 is a cross-sectional view of the display module DM, according to an embodiment.

In an embodiment and referring to FIG. 4, the display module DM may include the display panel DP and an input sensing layer ISL. The display panel DP may include a base layer BL, a circuit layer DP-CL, a display element layer DP-ED, and an encapsulation layer TFE.

In an embodiment, the circuit layer DP-CL may be disposed on an upper surface of the base layer BL. The base layer BL may be a flexible substrate that is bendable, foldable, or rollable. The base layer BL may be a glass substrate, a metal substrate, or a polymer substrate, however, it should not be limited thereto or thereby. According to an embodiment, the base layer BL may be an inorganic layer, an organic layer, or a composite material layer. The base layer BL may have substantially the same shape as the display panel DP.

In an embodiment, the base layer BL may have a multi-layer structure. For instance, the base layer BL may include a first synthetic resin layer, a second synthetic resin layer, and inorganic layers disposed between the first synthetic resin layer and the second synthetic resin layer. Each of the first and second synthetic resin layers may include a polyimide-based resin, however, it should not be particularly limited.

In an embodiment, the circuit layer DP-CL may be disposed on the base layer BL. The circuit layer DP-CL may include a plurality of insulating layers, a plurality of semiconductor patterns, a plurality of conductive patterns, and a plurality of signal lines. The circuit layer DP-CL may include a pixel driving circuit. Hereinafter, unless otherwise specified, the expression "Components A and B are disposed on the same layer." means that components A and B are formed through the same process and contain the same material or have the same stack structure. The conductive patterns or semiconductor patterns disposed on the same layer may be interpreted as described above.

In an embodiment, the display element layer DP-ED may be disposed on the circuit layer DP-CL. The display element layer DP-ED may include a light emitting element. For example, the light emitting element may include an organic light emitting material, an inorganic light emitting material, an organic-inorganic light emitting material, a quantum dot, a quantum rod, a micro-LED, or a nano-LED.

In an embodiment, the encapsulation layer TFE may be disposed on the display element layer DP-ED. The encapsulation layer TFE may protect the display element layer DP-ED, i.e., the light emitting element, from moisture, oxygen, and a foreign substance such as dust particles. The encapsulation layer TFE may include at least one encapsulation inorganic layer. The encapsulation layer TFE may include a stack structure in which a first encapsulation inorganic layer, an encapsulation organic layer, and a second encapsulation inorganic layer are sequentially stacked.

In an embodiment, the input sensing layer ISL may be disposed directly on the display panel DP. The input sensing layer ISL may sense a user's input by an electromagnetic induction method or a capacitive method. The display panel DP and the input sensing layer ISL may be formed through successive processes. The expression "being directly disposed on" as used herein may mean that no intervening elements are disposed between the input sensing layer ISL and the display panel DP. That is, a separate adhesive layer may not be disposed between the input sensing layer ISL and the display panel DP.

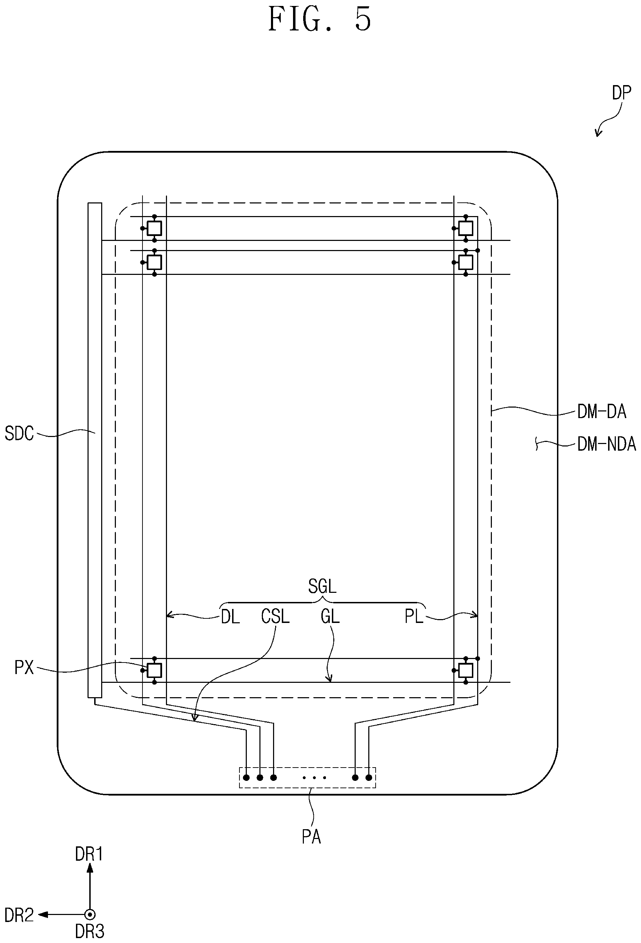

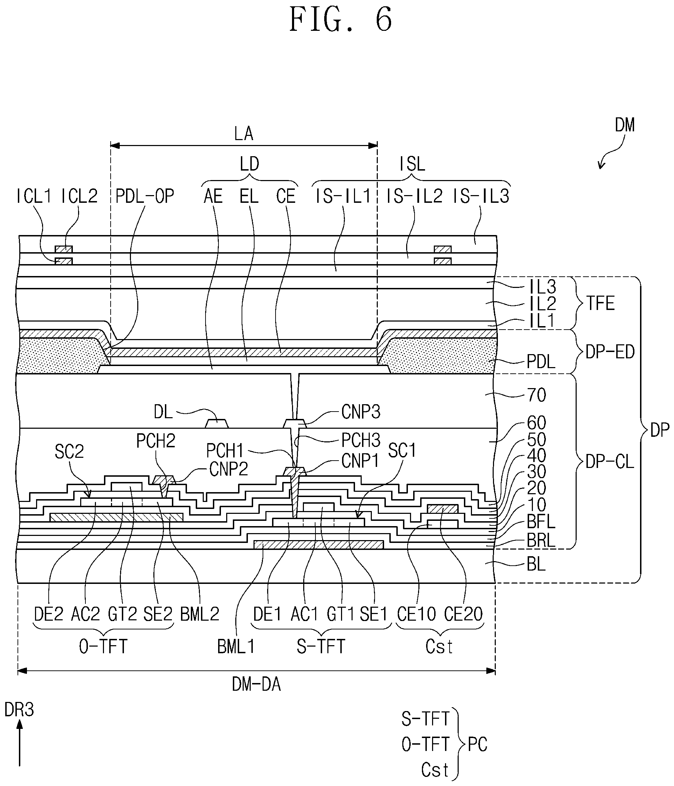

FIG. 5 is a plan view of the display panel DP, according to an embodiment. FIG. 6 is a cross-sectional view of the display module DM, according to an embodiment.

In an embodiment and referring to FIG. 5, the display panel DP may include a scan driving circuit SDC, a plurality of signal lines SGL, and a plurality of pixels PX. The pixels PX may be arranged in the display area DM-DA. Each of the pixels PX may include the light emitting element and the pixel driving circuit connected to the light emitting element. The scan driving circuit SDC, the signal lines SGL, and the pixel driving circuit may be included in the circuit layer DP-CL shown in FIG. 4.

In an embodiment, the scan driving circuit SDC may include a gate driving circuit. The gate driving circuit may generate a plurality of scan signals and may sequentially output the scan signals to a plurality of scan lines GL described later. The scan driving circuit SDC may further include a light emission driving circuit distinguished from the gate driving circuit. The light emission driving circuit may further output scan signals to another group of scan lines.

In an embodiment, the scan driving circuit SDC may include a plurality of thin film transistors formed through the same processes, e.g., a low temperature polycrystalline silicon (LTPS) process or a low temperature polycrystalline oxide (LTPO) process, as the pixel driving circuit.

In an embodiment, the signal lines SGL may include the scan lines GL, data lines DL, a power line PL, and a control signal line CSL. Each of the scan lines GL may be connected to a corresponding pixel PX among the pixels PX, and each of the data lines DL may be connected to a corresponding pixel PX among the pixels PX. The power line PL may be connected to the pixels PX. The data lines DL may provide data signals to the pixels PX. The control signal line CSL may provide control signals to the scan driving circuit SDC.

In an embodiment, the power line PL may be provided in plural. As an example, the power line PL may include a first power line receiving a first power supply voltage and a second power line receiving a second power supply voltage having a level higher than the first power supply voltage. The first power supply voltage may be provided to the pixel PX via the first power line, and the second power supply voltage may be provided to the pixel PX via the second power line. One control signal line CSL is shown in FIG. 5 as a representative example, however, in another embodiment, the control signal line CSL may be provided in plural.

In an embodiment, the scan lines GL, the data lines DL, and the power line PL may overlap the display area DM-DA and the non-display area DM-NDA, and the control signal line CSL may overlap the non-display area DM-NDA. Each of the signal lines SGL may have an integral shape but may include a plurality of portions disposed on different layers. The different portions distinguished from each other by an insulating layer may be connected to each other via a contact hole defined through the insulating layer. For instance, the data lines DL may include a first portion disposed in the display area DM-DA and a second portion disposed in the non-display area DM-NDA and disposed on a different layer from the first portion. The first portion and the second portion may include different materials from each other and may have different stack structures from each other.

In an embodiment, the signal lines SGL may be electrically connected to the main circuit board MCB shown in FIG. 3 via the pad area PA.

FIG. 6 shows a cross-section of the display module DM corresponding to the pixel PX of FIG. 5, according to an embodiment.

In an embodiment, the pixel driving circuit PC that drives the light emitting element LD may include a plurality of pixel driving elements. The pixel driving circuit PC may include a plurality of transistors S-TFT and O-TFT and a capacitor Cst. The transistors may include a silicon transistor S-TFT and an oxide transistor O-TFT. FIG. 6 shows the silicon transistor S-TFT and the oxide transistor O-TFT as a representative example of the transistors. The pixel driving circuit PC of FIG. 6 is merely an example, and components of the pixel driving circuit PC should not be limited thereto or thereby. The pixel driving circuit PC may include only one type of transistor between the silicon transistor S-TFT and the oxide transistor O-TFT.

In an embodiment and referring to FIG. 6, the base layer BL has a single-layer structure. The base layer BL may include a synthetic resin such as polyimide. The base layer BL may be formed by coating a synthetic resin layer on a work substrate (or a carrier substrate). When the display module DM is completed through subsequent processes, the work substrate may be removed.

In an embodiment and referring to FIG. 6, a first shielding electrode (or a shielding electrode) BML1 may be disposed on the base layer BL. The first shielding electrode BML1 may receive a bias voltage. The first shielding electrode BML1 may receive the first power supply voltage. The first shielding electrode BML1 may prevent an electric potential caused by a polarization phenomenon from exerting influence on the silicon transistor S-TFT. The first shielding electrode BML1 may prevent an external light from reaching the silicon transistor S-TFT. According to an embodiment, the first shielding electrode BML1 may be a floating electrode isolated from other electrodes or lines. The first shielding electrode BML1 may be disposed to correspond to the silicon transistor S-TFT. The first shielding electrode BML1 may include a metal material, e.g., molybdenum.

In an embodiment, a barrier layer BRL may be disposed on the base layer BL and the first shielding electrode BML1. The barrier layer BRL may prevent a foreign substance from entering thereinto from the outside. The barrier layer BRL may include at least one inorganic layer. The barrier layer BRL may include a silicon oxide layer and a silicon nitride layer. Each of the silicon oxide layer and the silicon nitride layer may be provided in plural, and the silicon oxide layers may be alternately stacked with the silicon nitride layers.

In an embodiment, a buffer layer BFL may be disposed on the barrier layer BRL. The buffer layer BFL may prevent metal atoms or impurities from being diffused to a first semiconductor pattern SC1 disposed thereon from the base layer BL. The buffer layer BFL may include at least one inorganic layer. The buffer layer BFL may include a silicon oxide layer and a silicon nitride layer.

In an embodiment, the first semiconductor pattern SC1 may be disposed on the buffer layer BFL. The first semiconductor pattern SC1 may include a silicon semiconductor. As an example, the silicon semiconductor may include amorphous silicon or polycrystalline silicon. For example, the first semiconductor pattern SC1 may include low temperature polycrystalline silicon.

In an embodiment, the first semiconductor pattern SC1 may have different electrical properties depending on whether it is doped or not. The first semiconductor pattern SC1 may include a first region having a relatively high conductivity and a second region having a relatively low conductivity. The first region may be doped with an N-type dopant or a P-type dopant. AP-type transistor may include a doped region doped with the P-type dopant, and an N-type transistor may include a doped region doped with the N-type dopant. The second region may be a non-doped region or a region doped at a concentration lower than that of the first region. In an embodiment, the first semiconductor pattern SC1 may be the N-type transistor.

In an embodiment, the first region may have a conductivity greater than that of the second region and may substantially serve as an electrode or signal line. The second region may substantially correspond to a channel area (or an active area) of a transistor. In other words, a portion of the first semiconductor pattern SC1 may be a channel of the transistor, another portion of the first semiconductor pattern SC1 may be a source or a drain of the transistor, and the other portion of the first semiconductor pattern SC1 may be a connection electrode or a connection signal line.

In an embodiment, a source area SE1, a channel area AC1 (or an active area), and a drain area DE1 of the silicon transistor S-TFT may be formed from the first semiconductor pattern SC1. The source area SE1 and the drain area DE1 may extend in opposite directions to each other from the channel area AC1.

In an embodiment, a first insulating layer 10 may be disposed on the buffer layer BFL. The first insulating layer 10 may cover the first semiconductor pattern SC1. The first insulating layer 10 may be an inorganic layer. The first insulating layer 10 may have a single-layer structure of a silicon oxide layer, however, it should not be limited thereto or thereby. An inorganic layer of the circuit layer DP-CL described later may have a single-layer or multi-layer structure and may include at least one of silicon nitride, silicon oxynitride, and silicon oxide, however, it should not be limited thereto or thereby.

In an embodiment, a gate (or a gate electrode) GT1 of the silicon transistor S-TFT may be disposed on the first insulating layer 10. The gate GT1 may be a portion of a metal pattern. The gate GT1 may overlap the channel area AC1. The gate GT1 may be used as a mask in a process of doping the first semiconductor pattern SC1. A first electrode CE10 of the capacitor Cst may be disposed on the first insulating layer 10. Different from those shown in FIG. 6, the gate GT1 and the first electrode CE10 may be provided integrally with each other.

In an embodiment, a second insulating layer 20 may be disposed on the first insulating layer 10 and may cover the gate GT1. An upper electrode (not shown) may be further disposed on the second insulating layer 20 to overlap the gate GT1. A second electrode CE20 may be disposed on the second insulating layer 20 to overlap the first electrode CE10. The upper electrode may be provided integrally with the second electrode CE20 when viewed in a plane.

In an embodiment, a second shielding electrode BML2 may be disposed on the second insulating layer 20. The second shielding electrode BML2 may be disposed to correspond to the oxide transistor O-TFT. According to an embodiment, the second shielding electrode BML2 may be omitted. According to an embodiment, the first shielding electrode BML1 may extend to a lower portion of the oxide transistor O-TFT and may replace the second shielding electrode BMI,2.

In an embodiment, a third insulating layer 30 may be disposed on the second insulating layer 20. A second semiconductor pattern SC2 may be disposed on the third insulating layer 30. The second semiconductor pattern SC2 may include a channel area AC2 of the oxide transistor O-TFT. The second semiconductor pattern SC2 may include a metal oxide semiconductor. The second semiconductor pattern SC2 may include a transparent conductive oxide (TCO), such as indium tin oxide (ITO), indium zinc oxide (IZO), indium gallium zinc oxide (IGZO), zinc oxide (ZnOx), or indium oxide (In₂O₃).

In an embodiment, the metal oxide semiconductor may include a plurality of areas SE2, AC2, and DE2 distinguished from each other depending on whether a transparent conductive oxide is reduced or not. The area (hereinafter, referred to as a reduced area) in which the transparent conductive oxide is reduced has a conductivity greater than that of the area (hereinafter, referred to as a non-reduced area) in which the transparent conductive oxide is not reduced. The reduced area may substantially act as a source/drain of a transistor or a signal line. The non-reduced area may substantially correspond to a semiconductor area (or a channel) of the transistor. In other words, a portion of the second semiconductor pattern SC2 may be the semiconductor area of the transistor, another portion of the second semiconductor pattern SC2 may be a source area SE2/a drain area DE2 of the transistor, and the other portion of the second semiconductor pattern SC2 may be a signal transmission area.

In an embodiment, a fourth insulating layer 40 may be disposed on the third insulating layer 30. As shown in FIG. 6, the fourth insulating layer 40 may cover the second semiconductor pattern SC2. According to an embodiment, the fourth insulating layer 40 may be an insulating pattern that overlaps a gate GT2 of the oxide transistor O-TFT and exposes the source area SE2 and the drain area DE2.

In an embodiment, the gate GT2 of the oxide transistor O-TFT may be disposed on the fourth insulating layer 40. The gate GT2 of the oxide transistor O-TFT may be a portion of a metal pattern. The gate GT2 of the oxide transistor O-TFT may overlap the channel area AC2.

In an embodiment, a fifth insulating layer 50 may be disposed on the fourth insulating layer 40 and may cover the gate GT2. Each of the first to fifth insulating layers 10 to 50, respectively, may be an inorganic layer.

In an embodiment, a first connection pattern CNP1 and a second connection pattern CNP2 may be disposed on the fifth insulating layer 50. The first connection pattern CNP1 and the second connection pattern CNP2 may be formed through the same process, and thus, the first connection pattern CNP1 and the second connection pattern CNP2 may include the same material and the same stack structure. The first connection pattern CNP1 may be connected to the drain area DE1 of the silicon transistor S-TFT via a first pixel contact hole PCH1 defined through the first, second, third, fourth, and fifth insulating layers 10, 20, 30, 40, and 50, respectively. The second connection pattern CNP2 may be connected to the source area SE2 of the oxide transistor O-TFT via a second pixel contact hole PCH2 defined through the fourth and fifth insulating layers 40 and 50, respectively. The connection relationship of the first connection pattern CNP1 and the second connection pattern CNP2 with respect to the silicon transistor S-TFT and the oxide transistor O-TFT should not be limited thereto or thereby.

In an embodiment, a sixth insulating layer 60 may be disposed on the fifth insulating layer 50. A third connection pattern CNP3 may be disposed on the sixth insulating layer 60. The third connection pattern CNP3 may be connected to the first connection pattern CNP1 via a third pixel contact hole PCH3 defined through the sixth insulating layer 60. The data line DL may be disposed on the sixth insulating layer 60. A seventh insulating layer 70 may be disposed on the sixth insulating layer 60 and may cover the third connection pattern CNP3 and the data line DL. The third connection pattern CNP3 and the data line DL may be formed through the same process, and thus, the third connection pattern CNP3 and the data line DL may include the same material and the same stack structure. Each of the sixth insulating layer 60 and the seventh insulating layer 70 may be an organic layer.

In an embodiment, the first shielding electrode BML1, the gate GT1 of the silicon transistor S-TFT, the second electrode CE20, and the gate GT2 of the oxide transistor O-TFT may include molybdenum (Mo), an alloy including molybdenum (Mo), titanium (Ti), or an alloy including titanium (Ti), which has a good heat resistance. The first connection pattern CNP1 and the second connection pattern CNP2 may include aluminium with high electrical conductivity. The first connection pattern CNP1 and the second connection pattern CNP2 may have a three-layer structure of titanium/aluminium/titanium.

In an embodiment, the light emitting element LD may include an anode (or a first electrode) AE, a light emitting layer EL, and a cathode (or a second electrode) CE. The anode AE of the light emitting element LD may be disposed on the seventh insulating layer 70. The anode AE may be a transmissive electrode, a semi-transmissive electrode, or a reflective electrode. The anode AE may have a stack structure of ITO/Ag/ITO sequentially stacked. Positions of the anode AE and the cathode CE may be interchanged.

In an embodiment, a pixel definition layer PDL may be disposed on the seventh insulating layer 70. The pixel definition layer PDL may be an organic layer. The pixel definition layer PDL may have a light absorbing property and may have a black color. As an example, the pixel definition layer PDL may include a black coloring agent. The black coloring agent may include a black dye or a black pigment. The black coloring agent may include a metal material, such as carbon black, chromium, or an oxide thereof. The pixel definition layer PDL may correspond to a light blocking pattern having a light blocking property.

In an embodiment, the pixel definition layer PDL may cover a portion of the anode AE. As an example, an opening PDL-OP may be defined through the pixel definition layer PDL to expose a portion of the anode AE. A light emitting area LA may be defined to correspond to the opening PDL-OP. In an embodiment, a hole control layer may be disposed between the anode AE and the light emitting layer EL. The hole control layer may include a hole transport layer and may further include a hole injection layer. An electron control layer may be disposed between the light emitting layer EL and the cathode CE. The electron control layer may include an electron transport layer and may further include an electron injection layer.

In an embodiment, the encapsulation layer TFE may cover the light emitting element LD. The encapsulation layer TFE may include a first encapsulation insulating layer IL1, a second encapsulation insulating layer IL2, and a third encapsulation insulating layer IL3. However, the invention should not be limited thereto or thereby, and, in an embodiment, the encapsulation layer TFE may further include a plurality of inorganic layers and a plurality of organic layers.

In an embodiment, the first encapsulation insulating layer IL1 may be an inorganic layer. The first encapsulation insulating layer IL1 may prevent external moisture or oxygen from entering the light emitting element LD. As an example, the first encapsulation insulating layer IL1 may include silicon nitride, silicon oxide, or a combination thereof. The first encapsulation insulating layer IL1 may be formed by a chemical vapor deposition process.

In an embodiment, the second encapsulation insulating layer IL2 may be an organic layer. The second encapsulation insulating layer IL2 may be disposed on the first encapsulation insulating layer IL1 and may be in contact with the first encapsulation insulating layer II,1. The second encapsulation insulating layer IL2 may provide a flat surface on the first encapsulation insulating layer IL1. Uneven portions formed on an upper surface of the first encapsulation insulating layer IL1 or particles existing on the upper surface of the first encapsulation insulating layer IL1 may be covered by the second encapsulation insulating layer IL2, and thus, it is possible to block the influence of the surface condition of the upper surface of the first encapsulation insulating layer IL1 on the components formed on the second encapsulation insulating layer IL2. In addition, the second encapsulation insulating layer IL2 may relieve a stress between layers that are in contact with each other. The second encapsulation insulating layer IL2 may be formed through a solution process such as a spin coating process, a slit coating process, or an inkjet process.

In an embodiment, the third encapsulation insulating layer IL3 may be disposed on the second encapsulation insulating layer IL2 and may cover the second encapsulation insulating layer IL2. The third encapsulation insulating layer IL3 may be formed stably on a relatively flat surface compared to being placed on the first encapsulation insulating layer II,1. The third encapsulation insulating layer IL3 may encapsulate moisture emitted from the second encapsulation insulating layer IL2 and may prevent moisture from leaking to outside.

In an embodiment, the third encapsulation insulating layer IL3 may be optically transparent. The third encapsulation insulating layer IL3 may have a transmittance equal to or greater than about 90% in a visible wavelength range. The third encapsulation insulating layer IL3 may have a relatively higher light transmittance than that of the first encapsulation insulating layer II,1. The third encapsulation insulating layer IL3 may be an inorganic layer. The third encapsulation insulating layer IL3 may include silicon oxide (SiOx) or silicon oxynitride (SiON). The third encapsulation insulating layer IL3 may be formed through a chemical vapor deposition process. Meanwhile, each of the first encapsulation insulating layer IL1, the second encapsulation insulating layer IL2, and the third encapsulation insulating layer IL3 may include a plurality of layers, and it should not be particularly limited.

In an embodiment, the input sensing layer ISL may include at least one conductive layer (or at least one sensor conductive layer) and at least one insulating layer (or at least one sensor insulation layer). In an embodiment, the input sensing layer ISL may include a first sensor insulating layer IS-IL1, a first conductive layer ICL1, a second sensor insulating layer IS-IL2, a second conductive layer ICL2, and a third sensor insulating layer IS-IL3. FIG. 6 schematically shows a conductive line of the first conductive layer ICL1 and a conductive line of the second conductive layer ICL2.

In an embodiment, the first sensor insulating layer IS-IL1 may be disposed directly on the display panel DP. The first sensor insulating layer IS-IL1 may be an inorganic layer including at least one of silicon nitride, silicon oxynitride, and silicon oxide. Each of the first conductive layer ICL1 and the second conductive layer ICL2 may have a single-layer structure or a multi-layer structure of layers stacked in the third direction DR3. The first conductive layer ICL1 and the second conductive layer ICL2 may include conductive lines that define an electrode of a mesh shape. The conductive line of the first conductive layer ICL1 and the conductive line of the second conductive layer ICL2 may be connected to each other via a contact hole defined through the second sensor insulating layer IS-IL2 or may not be connected to each other. The connection relationship between the conductive line of the first conductive layer ICL1 and the conductive line of the second conductive layer ICL2 may be determined according to the type of sensor formed as the input sensing layer ISL.

In an embodiment, the first conductive layer ICL1 and the second conductive layer ICL2, which have the single-layer structure, may include a metal layer or a transparent conductive layer. The metal layer may include molybdenum, silver, titanium, copper, aluminium, or alloys thereof. The transparent conductive layer may include a transparent conductive oxide, such as indium tin oxide (ITO), indium zinc oxide (IZO), zinc oxide (ZnOx), indium zinc tin oxide (ITZO), or the like. In addition, the transparent conductive layer may include conductive polymer such as PEDOT, metal nanowire, graphene, or the like.

In an embodiment, the first conductive layer ICL1 and the second conductive layer ICL2, which have the multi-layer structure, may include metal layers. The metal layers may have a three-layer structure of titanium/aluminium/titanium. The first conductive layer ICL1 and the second conductive layer ICL2, which have the multi-layer structure, may include at least one metal layer and at least one transparent conductive layer. The second insulating sensor layer IS-IL2 may be disposed between the first conductive layer ICL1 and the second conductive layer ICL2. The third sensor insulating layer IS-IL3 may cover the second conductive layer ICL2. According to an embodiment, the third sensor insulating layer IS-IL3 may be omitted. The second sensor insulating layer IS-II,2 and the third sensor insulating layer IS-IL3 may include an inorganic layer or an organic layer.

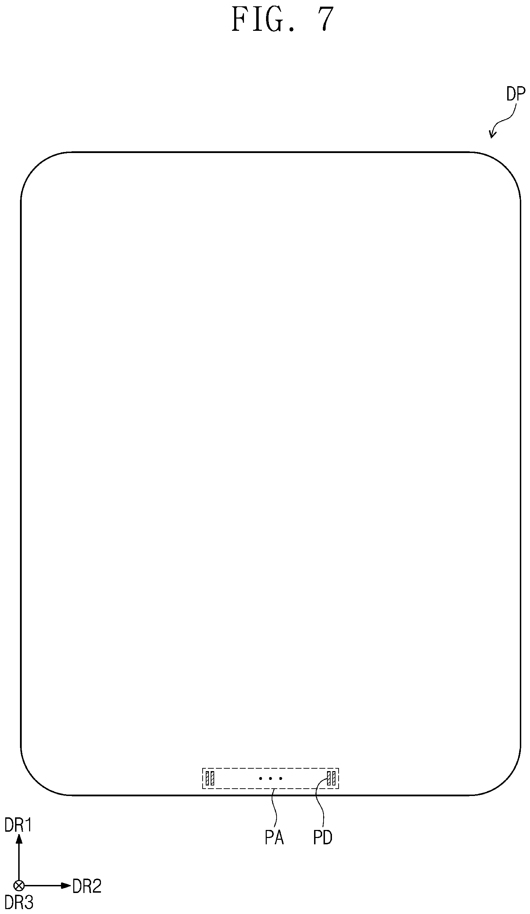

FIG. 7 is a plan view of the display panel DP, according to an embodiment. In detail, FIG. 7 is a plan view of the display panel DP when viewed in the third direction DR3.

In an embodiment and referring to FIG. 7, a pad electrode PD may be disposed on the rear surface of the display panel DP. In detail, the pad electrode PD may be disposed in the pad area PA. The pad electrode PD may be provided in plural. The pad electrodes PD may be arranged in the second direction DR2.

In an embodiment, the signal lines SGL (refer to FIG. 5) arranged in the display panel DP may be electrically connected to the circuit board FCB shown in FIG. 3 via the pad area PA. As an example, in an embodiment, the signal lines SGL may be arranged in the pad area PA and may be connected to the pad electrodes PD, which are spaced apart from the signal lines SGL in the first direction DR1, through the connection electrode. Although not shown in the figures, the pad electrodes PD may be disposed on the rear surface of the display panel DP and may be electrically connected to the flexible circuit board FCB (refer to FIG. 2). The connection between the circuit board FCB and the signal lines SGL will be described in detail later.

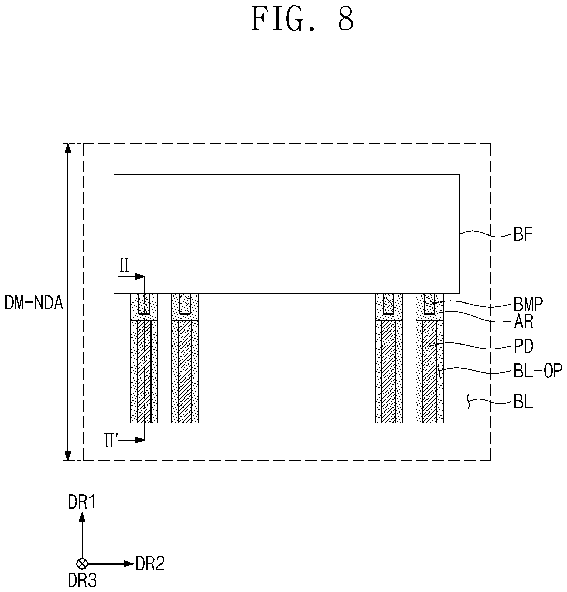

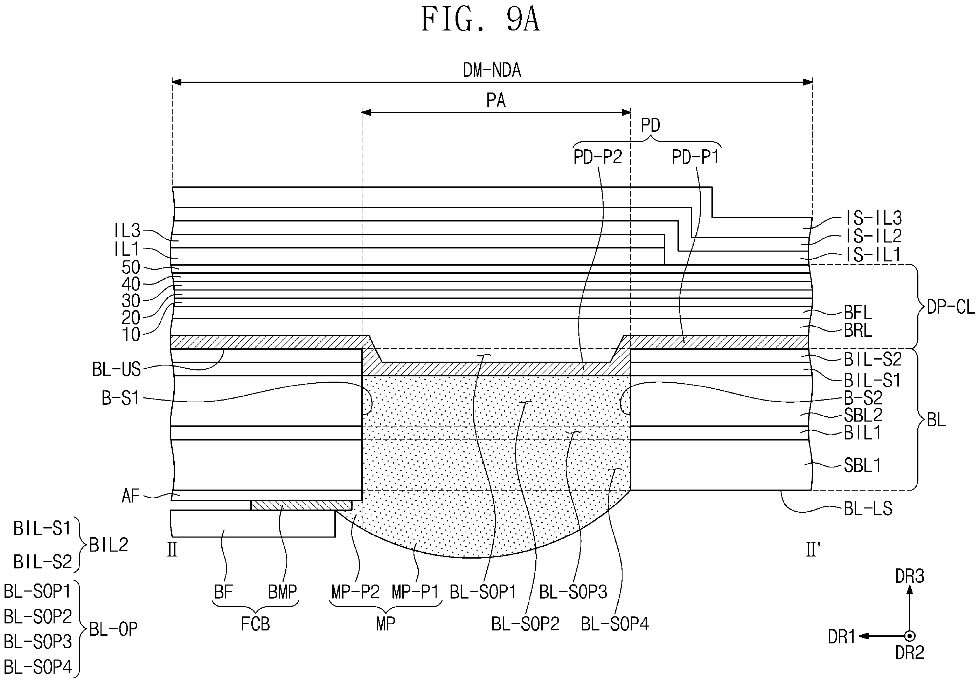

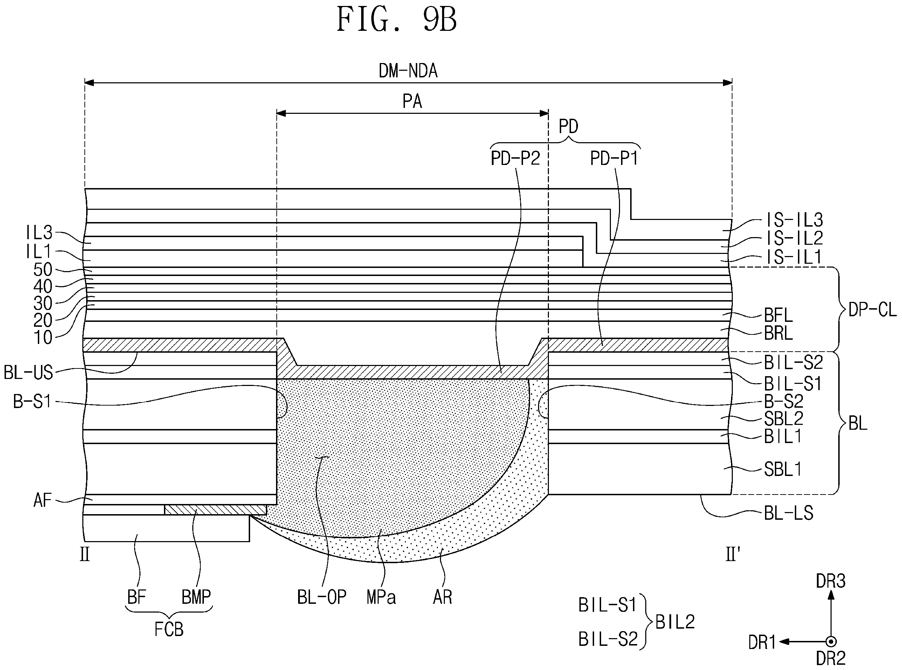

FIG. 8 is an enlarged plan view of a portion of the display device, according to an embodiment. FIG. 9A is a cross-sectional view of a portion of the display device taken along a line II-II' of FIG. 8, according to an embodiment. FIG. 9B is a cross-sectional view of a portion of a display device taken along a line II-II' of FIG. 8, according to an embodiment. FIGS. 8, 9A, and 9B are views showing structures in which the circuit board FCB is attached to the display panel DP, according to an embodiment.

In an embodiment and referring to FIGS. 8 and 9A, the display device DD may include the plural pad electrodes PD. The pad electrodes PD may be disposed on the same layer as the first shielding electrode BML1 shown in FIG. 6. The pad electrodes PD and the first shielding electrode BML1 may be formed through the same process. As an example, the pad electrodes PD and the first shielding electrode BML1 may be formed in the non-display area DM-NDA and the display area DM-DA, respectively, by providing a single metal layer on the base layer BL and patterning the metal layer. Although not shown in the figures, the pad electrodes PD may be electrically connected to the data line DL shown in FIG. 5 via a separate connection electrode.

In an embodiment, the pad electrodes PD may be exposed to the outside through a lower surface BL-LS of the base layer BL to allow the circuit board FCB to be bonded to the pad electrodes PD at a rear surface side of the display panel DP, however, the invention should not be limited thereto or thereby. According to an embodiment, the pad electrodes PD may be exposed to the outside through a contact hole without being directly exposed to the outside. The lower surface BL-LS of the base layer BL may face an upper surface BL-US of the base layer BL in the third direction DR3.

In an embodiment, the base layer BL may include a first sub-base layer SBL1, a first base inorganic layer BIL1, a second sub-base layer SBL2, and a second base inorganic layer BIL2, which are sequentially stacked. The first base inorganic layer BIL1 may be disposed on the first sub-base layer SBL1, the second sub-base layer SBL2 may be disposed on the first base inorganic layer BIL1, and the second base inorganic layer BIL2 may be disposed on the second sub-base layer SBL2.

In an embodiment, the first sub-base layer SBL1 and the second sub-base layer SBL2 may include a synthetic resin material, e.g., polyimide. The first base inorganic layer BIL1 and the second base inorganic layer BIL2 may include an inorganic material. As an example, the first base inorganic layer BIL1 and the second base inorganic layer BIL2 may include silicon nitride, silicon oxynitride, or silicon oxide. The second base inorganic layer BIL2 may include a plurality of layers. As an example, the second base inorganic layer BIL2 may include a first sub-base inorganic layer BIL-S1 and a second sub-base inorganic layer BIL-S2. The first sub-base inorganic layer BIL-S1 may include amorphous silicon (a-Si). The second sub-base inorganic layer BIL-S2 may include an inorganic material. As an example, in an embodiment, the second sub-base inorganic layer BIL-S2 may include silicon nitride, silicon oxynitride, or silicon oxide.

In an embodiment, the base layer BL may be provided with a base opening (or a first opening) BL-OP defined therethrough to expose the pad electrodes PD to the outside. The base layer BL may include a first side surface B-S1 and a second side surface B-S2 facing the first side surface B-S1 to define the base opening BL-OP. The first side surface B-S1 and the second side surface B-S2 may be referred to as one side surface and the other side surface of the base layer BL. Referring to FIG. 8, the base opening BL-OP may be provided in plural to correspond to the pad electrodes PD. A width in the first direction DR1 of the base opening BL-OP may be uniform in the third direction DR3, however, it should not be limited thereto or thereby. According to an embodiment, the width in the first direction DR1 of the base opening BL-OP may gradually increase in the third direction DR3.

In an embodiment, the base opening BL-OP may include a plurality of sub-openings BL-SOP1, BL-SOP2, BL-SOP3, and BL-SOP4. The sub-openings BL-SOP1, BL-SOP2, BL-SOP3, and BL-SOP4 may include a first sub-opening BL-SOP1, a second sub-opening BL-SOP2, a third sub-opening BL-SOP3, and a fourth sub-opening BL-SOP4. The first sub-opening BL-SOP1 may be defined through the second base inorganic layer BIL2, the second sub-opening BL-SOP2 may be defined through the second sub-base layer SBL2, the third sub-opening BL-SOP3 may be defined through the first base inorganic layer BIL1, and the fourth sub-opening BL-SOP4 may be defined through the first sub-base layer SBL1. The pad electrodes PD may be exposed to the outside via the second sub-opening BL-SOP2 defined through the second sub-base layer SBL2.

In an embodiment, the pad electrodes PD may extend in the first direction DR1 and may be arranged in the second direction DR2, however, the shape and arrangement of the pad electrodes PD should not be limited thereto or thereby. The pad electrodes PD may overlap the non-display area DM-NDA. As an example, in an embodiment, the pad electrodes PD may be arranged in the pad area PA.

In an embodiment and as shown in FIG. 9A, a portion of the pad electrodes PD may be disposed in the base opening BL-OP. The base opening BL-OP may completely penetrate the base layer BL. The pad electrodes PD may be embedded in the circuit layer DP-CL disposed on the base layer BL. The pad electrodes PD included in the circuit layer DP-CL may be exposed to the outside via the base opening BL-OP that completely penetrates the base layer BL.

In an embodiment, the pad electrodes PD may be disposed on the base layer BL and may include a first pad portion PD-P1 that does not overlap the base opening BL-OP and a second pad portion PD-P2 that overlaps the base opening BL-OP. The first pad portion PD-P1 may be disposed directly on the second base inorganic layer BIL2. The first pad portion PD-P1 and the second pad portion PD-P2 may be formed through the same process as the first shielding electrode BML1 disposed on the base layer BL shown in FIG. 6. The first pad portion PD-P1 and the second pad portion PD-P2 may include the same material as the first shielding electrode BML1. The first pad portion PD-P1 and the second pad portion PD-P2 may include a metal material, for example, molybdenum.

In an embodiment, the second pad portion PD-P2 may be disposed in the pad area PA. The pad electrodes PD shown in FIG. 8 may correspond to the second pad portion PD-P2 shown in FIG. 9A. The second pad portion PD-P2 may be disposed in the first sub-opening BL-SOP1. The second pad portion PD-P2 may be exposed to the outside via the second sub-opening BL-SOP2.

In an embodiment, although not shown in the figures, the display panel DP may include a first voltage line and a second voltage line, which receive different voltages from each other. The first voltage line may receive a first voltage, and the second voltage line may receive a second voltage higher than the first voltage. According to an embodiment, the first voltage may be the first power supply voltage, and the second voltage may be the second power supply voltage.

In an embodiment, the circuit board FCB may be attached to the display panel DP after being bent to the rear surface of the display panel DP. An adhesive layer AF may be disposed between the circuit board FCB and the lower surface BL-LS of the base layer BL. The circuit board FCB may be fixed to the lower surface BL-LS of the base layer BL by the adhesive layer AF. As an example, the circuit board FCB may be disposed to be spaced apart from the base opening BL-OP.

In an embodiment, the circuit board FCB may include a base film BF and a bump electrode BMP disposed on the base film BF. The base film BF may be formed as a single body and may be electrically connected to a plurality of bump electrodes BMP. In this case, the base film BF may include a plurality of lines therein, however, it should not be limited thereto or thereby. According to an embodiment, the base film BF may only be attached to the bump electrodes BMP and may not be electrically connected to the bump electrodes BMP. The base film BF may include a synthetic resin material, e.g., polyimide. The bump electrodes BMP may be disposed on the base film BF.

In an embodiment, the bump electrodes BMP may overlap the first pad portion PD-P1 of the pad electrodes PD but not overlap the second pad portion PD-P2 of the pad electrodes PD when viewed in the plane. The bump electrodes BMP may be electrically connected to the pad electrodes PD. The bump electrodes BMP may be formed to correspond to the pad electrodes PD. That is, one bump electrode BMP may correspond to one pad electrode PD. The bump electrodes BMP may extend in the first direction DR1 and may be arranged in the second direction DR2. The pad electrodes PD may have a size greater than a size of the bump electrodes BMP when viewed in the plane.

In an embodiment, the adhesive layer AF may be disposed between the base film BF and the pad electrodes PD. According to an embodiment, the adhesive layer AF may include a non-conductive material. As an example, the adhesive layer AF may include a non-conductive film. An edge of the adhesive layer AF may be aligned to be substantially parallel to the first side surface B-S1 of the base layer BL in the third direction DR3.

In an embodiment, the bump electrodes BMP may be electrically connected to the pad electrodes PD. In detail, the display device DD (refer to FIG. 2) may further include metal patterns MP that electrically connect the bump electrodes BMP and the pad electrodes PD. The metal patterns MP may be disposed on the pad electrodes PD and the bump electrodes BMP and may electrically connect the pad electrodes PD and the bump electrodes BMP. The metal patterns MP may be provided in numbers corresponding to each of the number of the pad electrodes PD and the number of the bump electrodes BMP.

In an embodiment, each of the metal patterns MP may be obtained by curing a metal ink. The metal patterns MP may include a solder paste. The metal patterns MP may be formed of the metal ink containing silver or copper. The metal patterns MP may be disposed to correspond to the pad electrodes PD exposed through the base openings BL-OP. The metal patterns MP may be formed by curing the metal ink and patterning the cured metal ink. The metal pattern MP may be formed at a low temperature and may bond and electrically connect the pad electrodes PD and the bump electrodes BMP together without a pressing process at a high temperature.

In an embodiment, each of the metal patterns MP may include a first portion MP-P1 that is in contact with the pad electrodes PD and a second portion MP-P2 that is in contact with the bump electrodes BMP of the circuit board FCB. The first portion MP-P1 may overlap the base opening BL-OP and may be disposed in the base opening BL-OP. In detail, the first portion MP-P1 may be disposed in the second, third, and fourth sub-openings BL-SOP2, BL-SOP3, and BL-SOP4, respectively. The first portion MP-P1 may be in contact with the pad electrodes PD at a boundary between the first and second sub-openings BL-SOP1 and BL-SOP2, respectively. The first portion MP-P1 may be directly in contact with the first side surface B-S1 and the second side surface B-S2 in the base opening BL-OP. That is, the first portion MP-P1 may be provided to fill the base opening BL-OP and may cover the first side surface B-S1 and the second side surface B-S2.

In an embodiment, the second portion MP-P2 may be disposed not to overlap the base opening BL-OP. The second portion MP-P2 may be disposed to cover the bump electrodes BMP exposed to the outside. An end of the second portion MP-P2 may be in contact with a side surface of the base film BF. The end of the second portion MP-P2 may not be in contact with the side surface of the base film BF. According to an embodiment, the end of the second portion MP-P2 may be formed to completely cover the side surface of the base film BF. The first portion MP-P1 and the second portion MP-P2 may be formed integrally with each other. That is, in the metal pattern MP, the first portion MP-P1 and the second portion MP-P2 are portions distinguished from each other for the convenience of explanation based on the base opening BL-OP. The pad electrodes PD may be electrically connected to the bump electrodes BMP by the first portion MP-P1 and the second portion MP-P2, which are provided integrally with each other.

In an embodiment, the pad electrodes PD embedded in the circuit layer DP-CL may be exposed via the base opening BL-OP that completely penetrates the base layer BL, and the metal patterns MP may be directly connected to the pad electrodes PD exposed via the base opening. Accordingly, in a method of manufacturing the display device DD (refer to FIG. 2), the connection electrode may not be required between the pad electrodes PD and the metal patterns MP, and thus, the manufacturing method of the display device DD may be simplified.

In an embodiment and referring to FIG. 9B, the display device DD (refer to FIG. 2) may further include an adhesive resin AR of which at least a portion is disposed in a base opening BL-OP. The adhesive resin AR may include an optical clear resin. However, a material for the adhesive resin AR should not be limited thereto or thereby and may include a conventional adhesive. As an example, the adhesive resin AR may include a pressure sensitive adhesive (PSA) or an optical clear adhesive (OCA).

In an embodiment, a portion of the adhesive resin AR may be disposed in the base opening BL-OP, and the other portion of the adhesive resin AR may be disposed outside the base opening BL-OP and may cover a metal pattern MPa. The adhesive resin AR and the metal pattern MPa may be provided to fill the base opening BL-OP. The metal pattern MPa may be in contact with a first side surface B-S1 and may cover the first side surface B-S1. A portion of the adhesive resin AR may be in contact with a second side surface B-S2 and may cover the second side surface B-S2. The adhesive resin AR may cover the metal pattern MPa exposed to the outside. As the adhesive resin AR and the metal pattern MPa are provided to completely fill the base opening BL-OP, a possibility of cracks occurring inside the display device DD may be reduced when the display device DD (refer to FIG. 2) receives external impacts and is bent around the base opening BL-OP.

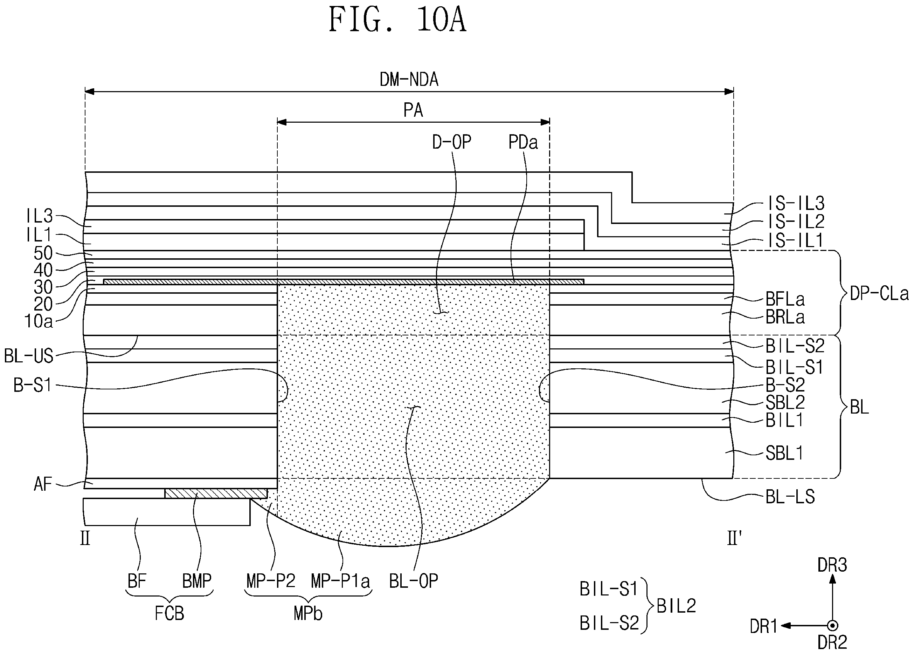

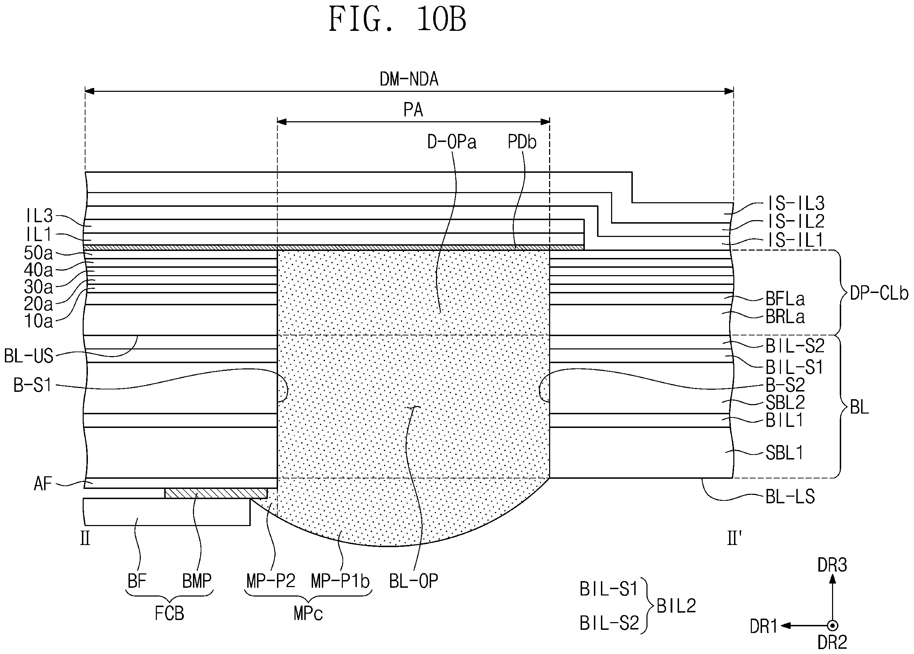

FIGS. 10A and 10B are cross-sectional views of a portion of display devices taken along a line II-II' of FIG. 8, according to an embodiments. In FIGS. 10A and 10B, detailed descriptions of the same elements as those in FIGS. 9A and 9B will be omitted.

In an embodiment and referring to FIG. 10A, a second opening D-OP may be formed through a circuit layer DP-CLa. In detail, the second opening D-OP may be formed through a barrier layer BRLa, a buffer layer BFLa, and a first insulating layer 10a of the circuit layer DP-CLa. Pad electrodes PDa disposed on the first insulating layer 10a may be exposed to the outside via the second opening D-OP. The second opening D-OP may overlap a base opening BL-OP when viewed in the plane. A width in the first direction DR1 of the second opening D-OP may be substantially the same as a width in the first direction DR1 of the base opening BL-OP. The second opening D-OP may be formed through the same process as the base opening BL-OP. That is, the second opening D-OP and the base opening BL-OP may have a continuous hole structure.

In an embodiment, the pad electrodes PDa may be disposed on the first insulating layer 10a. The pad electrodes PDa may be formed through the same process as the gate electrode GT1 disposed on the first insulating layer 10 shown in FIG. 6. That is, the pad electrodes PDa and the gate electrode GT1 (refer to FIG. 6) may be disposed on the same layer. The pad electrodes PDa may include the same material as the gate electrode GT1. The pad electrodes PDa may include molybdenum (Mo), an alloy including molybdenum (Mo), titanium (Ti), or an alloy including titanium (Ti). However, the invention should not be limited thereto or thereby, and the pad electrodes PDa may be formed through the same process as a second shielding electrode BML2 (refer to FIG. 6) disposed on a second insulating layer 20 or a gate electrode GT2 (refer to FIG. 6) disposed on a third insulating layer 30.

In an embodiment, a metal pattern MPb may include a first portion MP-P1a that is in contact with the pad electrodes PDa and a second portion MP-P2 that is in contact with bump electrodes BMP of a circuit board FCB. The first portion MP-P1a may be disposed in the second opening D-OP and the base opening BL-OP. The first portion MP-P1a may be formed to fill the second opening D-OP and the base opening BL-OP. The pad electrodes PDa may be electrically connected to the bump electrodes BMP by the first portion MP-P1a and the second portion MP-P2.

In an embodiment and referring to FIG. 10B, a second opening D-OPa may be formed through a circuit layer DP-CLb. In detail, the second opening D-OPa may be formed through a barrier layer BRLa, a buffer layer BFLa, and first, second, third, fourth, and fifth insulating layers 10a, 20a, 30a, 40a, and 50a, respectively, of the circuit layer DP-CLb. Pad electrodes PDb disposed on the fifth insulating layer 50a may be exposed through the second opening D-OPa. The second opening D-OPa may overlap a base opening BL-OP when viewed in the plane. A width in the first direction DR1 of the second opening D-OPa may be substantially the same as a width in the first direction DR1 of the base opening BL-OP. The second opening D-OPa may be formed through the same process as the base opening BL-OP. That is, the second opening D-OPa and the base opening BL-OP may have a continuous hole structure.

In an embodiment, the pad electrodes PDb may be disposed on the fifth insulating layer 50a. The pad electrodes PDb may be formed through the same process as the first connection pattern (or the connection pattern CNP1) disposed on the fifth insulating layer 50 shown in FIG. 6. The pad electrodes PDb may include the same material as the first connection pattern CNP1. The pad electrodes PDb may include aluminium, which has high electrical conductivity. The pad electrodes PDb may have a three-layer structure of titanium/aluminium/titanium, however, the invention should not be limited thereto or thereby. According to an embodiment, the pad electrodes PDb may be formed through the same process as the third connection pattern CNP3 (refer to FIG. 6) disposed on the sixth insulating layer 60 (refer to FIG. 6).

In an embodiment, a metal pattern MPc may include a first portion MP-P1b that is in contact with the pad electrodes PDb and a second portion MP-P2 that is in contact with bump electrodes BMP of a circuit board FCB. The first portion MP-P1b may be disposed in the second opening D-OPa and the base opening BL-OP. The first portion MP-P1b may be formed to fill the second opening D-OPa and the base opening BL-OP. The pad electrodes PDb may be electrically connected to the bump electrodes BMP by the first portion MP-P1b and the second portion MP-P2.

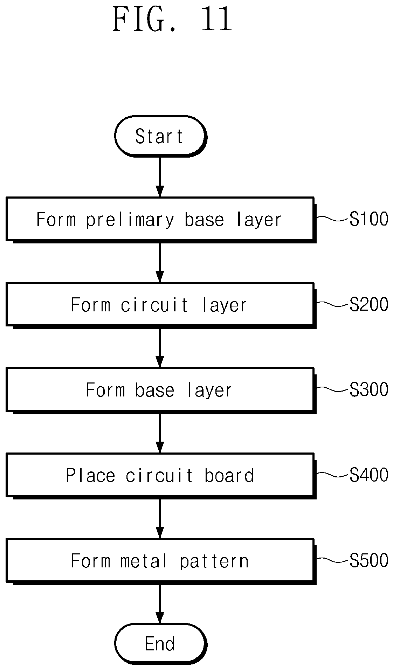

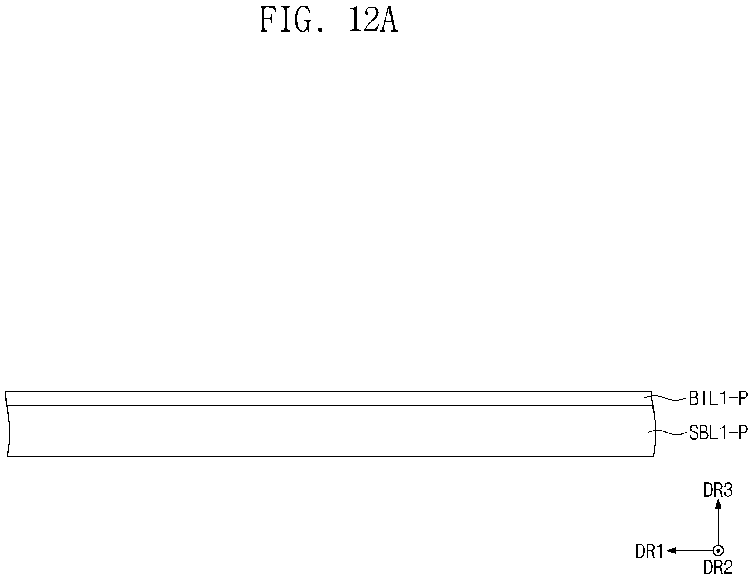

FIG. 11 is a flowchart illustrating a method of manufacturing a display device, according to an embodiment. FIGS. 12A to 12I are views illustrating processes of a method of manufacturing a display device, according to an embodiment. Hereinafter, in FIGS. 11 and 12A to 12I, the same reference numerals denote the same elements in FIGS. 1 to 10B, and thus, detailed descriptions of the same elements will be omitted.

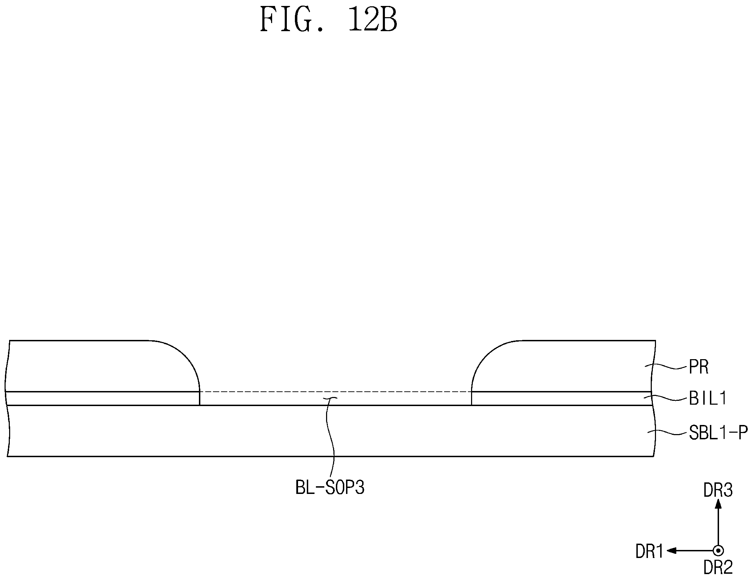

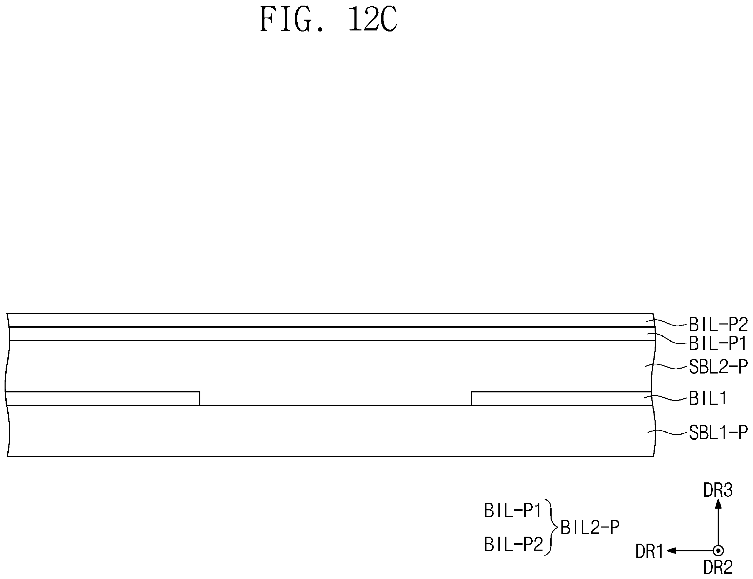

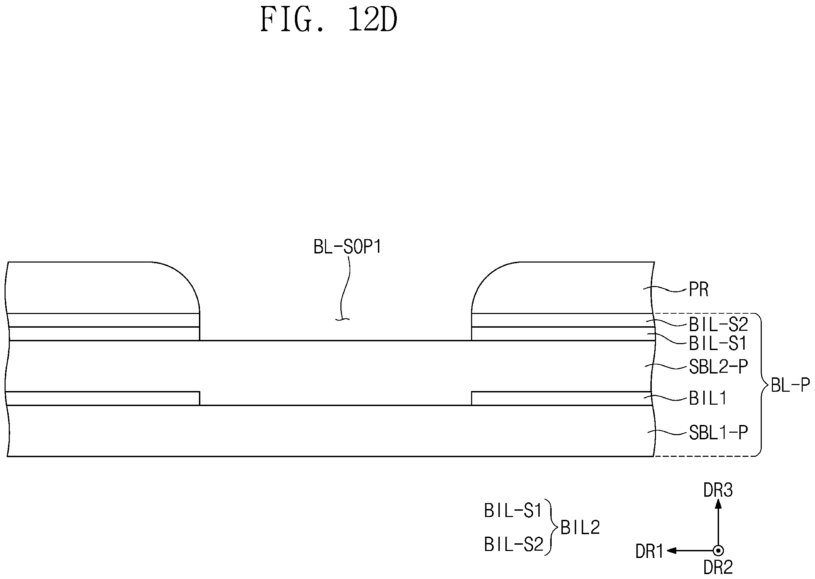

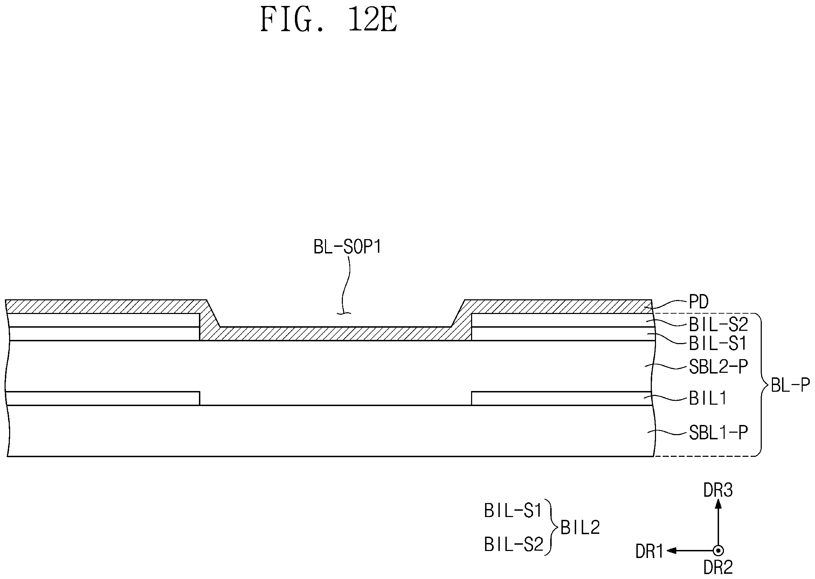

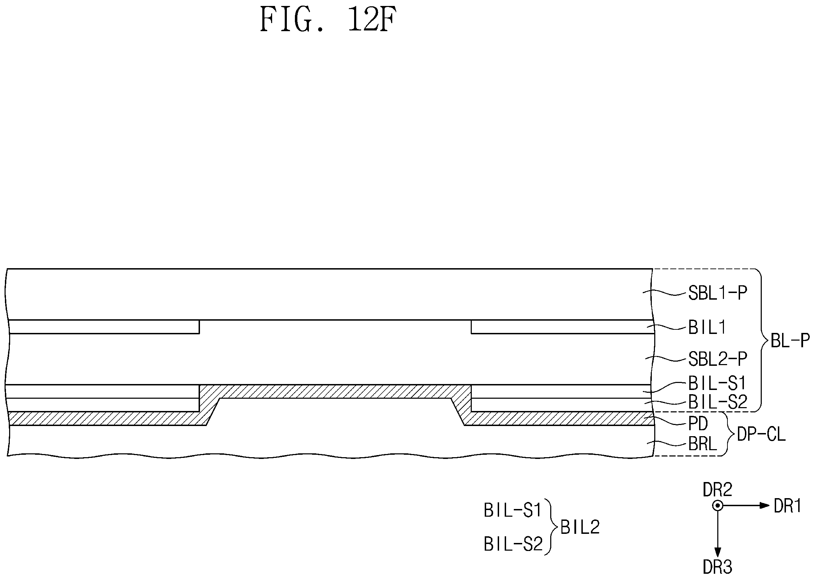

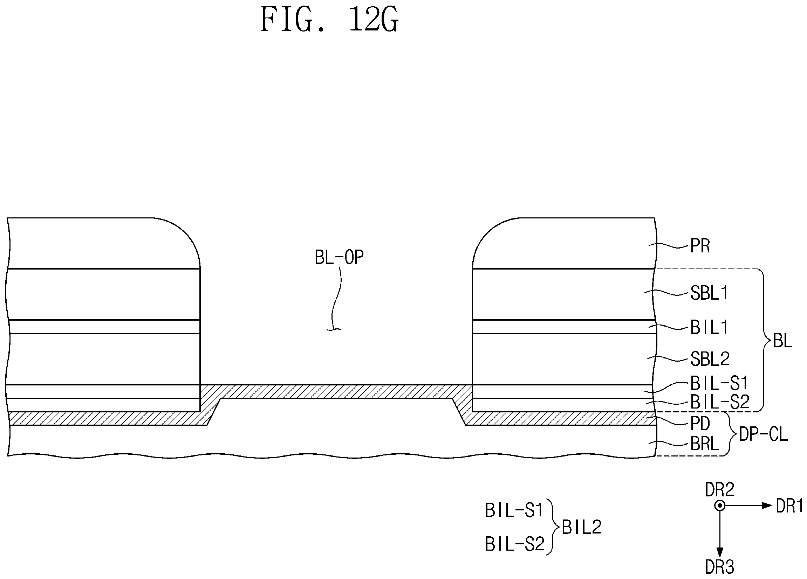

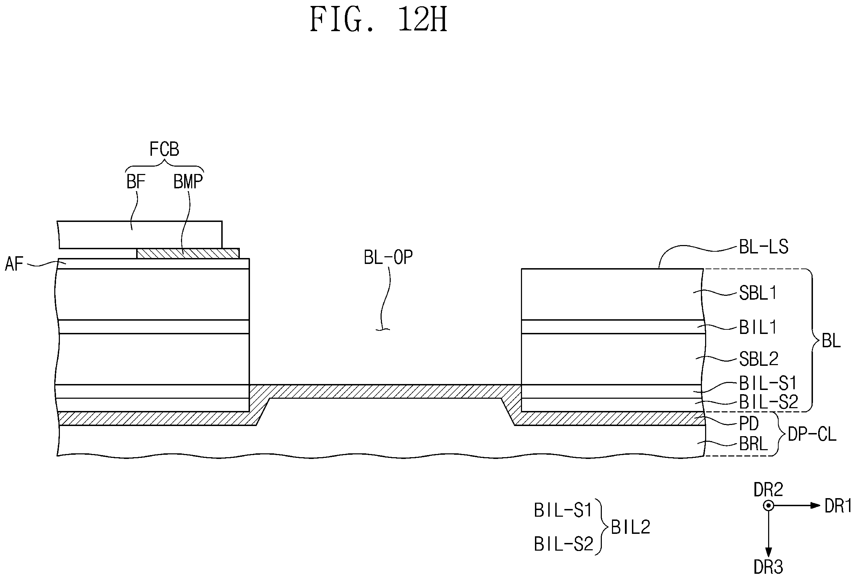

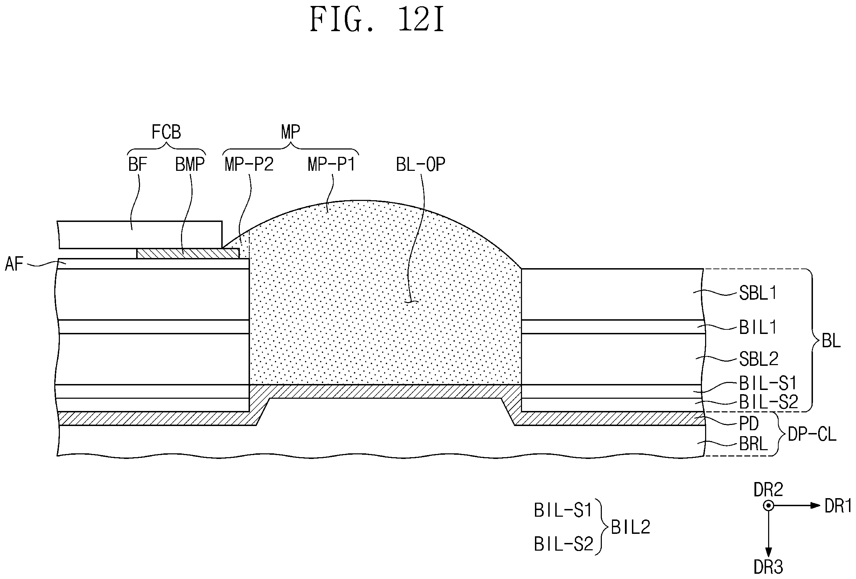

In an embodiment and referring to FIGS. 11 and 12Ato 12I, the manufacturing method of the display device DD (refer to FIG. 2) may include forming a preliminary base layer BL-P (S100), forming the circuit layer DP-CL (S200), forming the base layer BL (S300), placing the circuit board FCB (S400), and forming the metal pattern MP (S500).

In an embodiment and referring to FIGS. 11 and 12A to 12D, the forming of the preliminary base layer BL-P may be performed (S 100).

In an embodiment and referring to FIG. 12A, the forming of the preliminary base layer BL-P (refer to FIG. 12C) (S 100) may include forming a first preliminary sub-base layer SBL1-P and forming a first preliminary base inorganic layer BIL1-P on the first preliminary sub-base layer SBL1-P.

In an embodiment and referring to FIG. 12B, the forming of the preliminary base layer BL-P (refer to FIG. 12C) (S100) may further include first preliminary-etching the first preliminary base inorganic layer BIL1-P (refer to FIG. 12A). In detail, a photoresist layer PR may be placed on the first preliminary base inorganic layer BIL1-P and the first preliminary-etching of the first preliminary base inorganic layer BIL1-P may be performed, and thus, the third sub-opening BL-SOP3 may be formed. The first preliminary-etching of the first preliminary base inorganic layer BIL1-P may be performed to prevent residues from remaining on the first preliminary base inorganic layer BIL1-P when the base opening BL-OP (refer to FIG. 12G) is formed in a subsequent process. According to an embodiment, the first preliminary-etching may be omitted. Although not shown in the figures, a preliminary photoresist layer may be disposed on the first preliminary base inorganic layer BIL1-P and the preliminary photoresist layer may be patterned using a mask to form the photoresist layer PR. The first base inorganic layer BIL1 through which the third sub-opening BL-SOP3 is defined may be formed after the first preliminary-etching.

In an embodiment and referring to FIG. 12C, the forming of the preliminary base layer BL-P (S100) may further include forming a second preliminary sub-base layer SBL2-P on the first base inorganic layer BIL1 and forming a second preliminary base inorganic layer BIL2-P on the second preliminary sub-base layer SBL2-P. The second preliminary base inorganic layer BIL2-P may include a plurality of layers. As an example, the second preliminary base inorganic layer BIL2-P may include a first sub-preliminary inorganic layer BIL-P1 and a second sub-preliminary inorganic layer BIL-P2 disposed on the first sub-preliminary inorganic layer BIL-P1.

In an embodiment and referring to FIG. 12D, the forming of the preliminary base layer BL-P (S100) may further include second preliminary-etching the second preliminary base inorganic layer BIL2-P (refer to FIG. 12C). In detail, the first sub-opening BL-SOP1 may be formed by placing a photoresist layer PR on the second preliminary base inorganic layer BIL2-P and second preliminary-etching the second preliminary base inorganic layer BIL2-P. The second preliminary-etching of the second preliminary base inorganic layer BIL2-P may be performed to prevent residues from remaining on the second preliminary base inorganic layer BIL2-P when the base opening BL-OP (refer to FIG. 12G) is formed in a subsequent process. According to an embodiment, the second preliminary-etching may be omitted. Although not shown in the figures, a preliminary photoresist layer may be disposed on the second preliminary base inorganic layer BIL2-P and the preliminary photoresist layer may be patterned using a mask to form the photoresist layer PR. The second base inorganic layer BIL2 through which the first sub-opening BL-SOP1 is defined may be formed after the second preliminary-etching. The second base inorganic layer BIL2 may include the first sub-base inorganic layer BIL-S1 and the second sub-base inorganic layer BIL-S2.

In an embodiment and referring to FIGS. 12A to 12D, the preliminary base layer BL-P including the first preliminary sub-base layer SBL1-P, the first base inorganic layer BIL1, the second preliminary sub-base layer SBL2-P, and the second base inorganic layer BIL2 may be provided.

In an embodiment and referring to FIGS. 11, 12E, and 12F, the forming of the circuit layer DP-CL (S200) may be performed after the forming of the preliminary base layer BL-P (S100).

In an embodiment and referring to FIG. 12E, the forming of the circuit layer DP-CL (S200) may include placing the pad electrode PD on the preliminary base layer BL-P. A portion of the pad electrode PD may be disposed on the second base inorganic layer BIL2, and the other portion of the pad electrode PD may be disposed on the second preliminary sub-base layer SBL2-P. In detail, the other portion of the pad electrode PD may be disposed in the first sub-opening BL-SOP1. Referring to FIGS. 6 and 12E, the pad electrode PD and the first shielding electrode BML1 may be formed through the same process. As an example, in an embodiment, each of the pad electrode PD and the first shielding electrode BML1 may be formed by forming a metal layer on the preliminary base layer BL-P and pattering the metal layer.

In an embodiment and referring to FIG. 12F, the forming of the circuit layer DP-CL (S200) may further include placing the barrier layer BRL (or an inorganic layer) on the pad electrode PD. In detail, after the barrier layer BRL is placed on the pad electrode PD, a process of turning upside down a structure including the preliminary base layer BL-P and the circuit layer DP-CL may be performed. Although not shown in detail in FIG. 12F, the circuit layer DP-CL may have the same configuration as the circuit layer DP-CL shown in FIG. 9A.

In an embodiment and referring to FIGS. 11, 12F, and 12G, the forming of the base layer BL (S300) may be performed after the forming of the circuit layer DP-CL (S200).

In an embodiment and referring to FIGS. 12F and 12G, the forming of the base layer BL (S300) may include etching the preliminary base layer BL-P. In detail, the base opening BL-OP may be formed by placing a photoresist layer PR on the preliminary base layer BL-P and etching the preliminary base layer BL-P. The pad electrode PD may be exposed via the base opening BL-OP that completely penetrates the base layer BL. A width in the first direction DR1 of the pad electrode PD exposed to the outside may be the same as a width in the first direction DR1 of the base opening BL-OP.

In an embodiment and referring to FIGS. 11 and 12H, the forming of the circuit board FCB (S400) may be performed after the forming of the base layer BL (S300).

In an embodiment and referring to FIG. 12H, the circuit board FCB may be disposed on the lower surface BL-LS of the base layer BL. The adhesive layer AF may be disposed between the circuit board FCB and the lower surface BL-LS of the base layer BL. The circuit board FCB may be fixed to the lower surface BL-LS of the base layer BL by the adhesive layer AF.

In an embodiment, the circuit board FCB may include the base film BF and the bump electrode BMP disposed on the base film BF. The base film BF may be formed in a single body and may be electrically connected to the bump electrode BMP. The bump electrode BMP may be fixed to the lower surface BL-LS of the base layer BL by the adhesive layer AF. Although not shown in figures, the circuit board FCB may be attached to the lower surface of the base layer BL while being in a bent state.

In an embodiment and referring to FIGS. 11 and 12I, the forming of the metal pattern MP (S500) may be performed after the forming of the circuit board FCB (S400).

In an embodiment and referring to FIG. 12I, the metal pattern MP may include the first portion MP-P1 that is in contact with the pad electrodes PD and the second portion MP-P2 that is in contact with the bump electrodes BMP of the circuit board FCB. The first portion MP-P1 may overlap the base opening BL-OP and may be disposed in the base opening BL-OP. The second portion MP-P2 may be disposed not to overlap the base opening BL-OP. The second portion MP-P2 may be disposed to cover the bump electrodes BMP exposed to the outside. The metal pattern MP may be formed by curing the metal ink. The metal pattern MP may be formed by curing the metal ink at a low temperature and patterning the cured metal ink. The pad electrode PD and the bump electrode BMP may be electrically connected to each other and may be bonded to each other by the metal pattern MP.

In an embodiment and referring to FIGS. 12I and 9B, the manufacturing method of the display device DD may further include forming the adhesive resin AR to cover the metal pattern MPa in the base opening BL-OP after the forming of the metal pattern MPa (S500). The adhesive resin AR may include an optically clear resin. However, a material for the adhesive resin AR should not be limited thereto or thereby, and the adhesive resin AR may include a conventional adhesive. As an example, the adhesive resin AR may include a pressure sensitive adhesive (PSA) or an optically clear adhesive (OCA). One portion of the adhesive resin AR may be disposed in the base opening BL-OP, and the other portion of the adhesive resin AR may be disposed outside the base opening BL-OP and may cover the metal pattern MPa. The adhesive resin AR and the metal pattern MPa may be provided to fill the base opening BL-OP.

In an embodiment and referring to FIGS. 11 and 12Ato 12I, the manufacturing method of the display device DD (refer to FIG. 2) may include the forming of the base opening BL-OP that completely penetrates the base layer BL to expose the pad electrodes PD embedded in the circuit layer DP-CL. As the pad electrodes PD are electrically connected to the bump electrodes BMP via the metal pattern MP disposed in the base opening BL-OP, which completely penetrates the base layer BL, the connection electrode may not be required between the pad electrodes PD and the bump electrodes BMP, and as a result, the manufacturing method of the display device DD may be simplified.

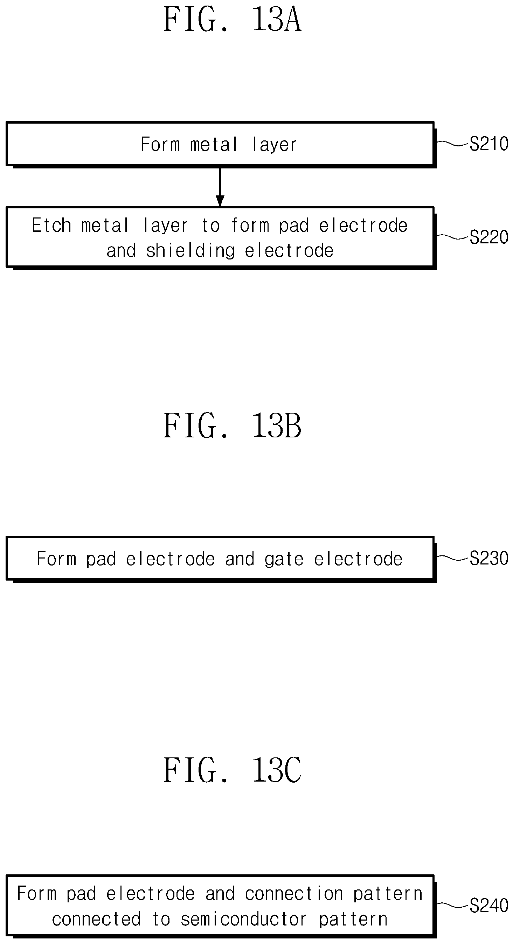

FIGS. 13Ato 13C are flowcharts illustrating the manufacturing method of the display device, according to an embodiment. FIGS. 13A to 13C illustrate processes included in the forming of the circuit layer DP-CL (S200). In FIGS. 13A to 13C, the same reference numerals denote the same elements in FIGS. 1 to 12I, and thus, detailed descriptions of the same elements will be omitted.

In an embodiment and referring to FIGS. 6, 12E, and 13A, the placing of the pad electrode PD on the preliminary base layer BL-P may include forming the metal layer on the preliminary base layer BL-P (S210) and etching the metal layer to form the pad electrode PD and the first shielding electrode (or the shielding electrode) BML1 (S220). The metal layer may be formed on the preliminary base layer BL-P when the pad electrode PD shown in FIG. 12E is formed, and the metal layer may be patterned to form the pad electrode PD disposed in the non-display area DM-NDA and the first shielding electrode BML1 disposed in the display area DM-DA. However, the invention should not be limited thereto or thereby, and the gate electrode GT1 disposed on the first insulating layer 10 and the connection pattern CNP1 disposed on the fifth insulating layer 50 may be formed by patterning the metal layer.

In an embodiment and referring to FIGS. 6, 9A to 10B, and 12E and 13B, the forming of the circuit layer DP-CL (S200) may include forming the pad electrode PDa and the gate electrode GT1 (S230). The metal layer may be formed on the first insulating layer 10a to form the pad electrode PDa shown in FIG. 10A, and the metal layer may be patterned to form the pad electrode PDa disposed in the non-display area DM-NDA and the gate electrode GT1 disposed in the display area DM-DA.

In an embodiment and referring to FIGS. 6, 9A to 10B, 12E, and 13C, the forming of the circuit layer DP-CL (S200) may include forming the pad electrode PDb and the first connection pattern (or the connection pattern) CNP1 (S240). A metal layer may be formed on the fifth insulating layer 50a to form the pad electrode PDb shown in FIG. 10B, and the metal layer may be patterned to form the pad electrode PDb disposed in the non-display area DM-NDA and the first connection pattern CNP1 disposed in the display area DM-DA.

Although the embodiments of the invention have been described, it is understood that the invention should not be limited to these embodiments, but rather various changes and modifications can be made by one ordinary skilled in the art within the spirit and scope of the invention.

Therefore, the invention should not be limited to any single embodiment described herein. Moreover, embodiments or parts of the embodiments may be combined in whole or in part without departing from the scope of the invention.

Embodiments are set out in the following clauses:
Clause 1. A method of manufacturing a display device, comprising:
   forming a preliminary base layer;
   placing a pad electrode on the preliminary base layer to form a circuit layer;
   etching the preliminary base layer to form a base layer through which a first opening is defined to expose the pad electrode to an outside;
   placing a circuit board on a lower surface of the base layer; and
   forming a metal pattern to electrically connect the pad electrode and the circuit board, wherein the metal pattern comprises:
      a first portion overlapping the first opening and being in contact with the pad electrode; and
      a second portion that does not overlap the first opening and being in contact with the circuit board.
Clause 2. The method of clause 1, wherein the forming of the preliminary base layer comprises:
   forming a first preliminary sub-base layer;
   forming a first preliminary base inorganic layer on the first preliminary sub-base layer;
   forming a second preliminary sub-base layer on the first preliminary base inorganic layer; and
   forming a second preliminary base inorganic layer on the second preliminary sub-base layer.
Clause 3. The method of clause 2, wherein the forming of the preliminary base layer further comprises:
   first preliminary-etching the first preliminary base inorganic layer to form a first base inorganic layer before the forming of the second preliminary sub-base layer; and
   second preliminary-etching the second preliminary base inorganic layer to form a second base inorganic layer before the placing of the pad electrode on the preliminary base layer.
Clause 4. The method of clause 3, wherein the placing of the pad electrode on the preliminary base layer comprises placing the pad electrode in a sub-opening formed through the second base inorganic layer by the second preliminary-etching.
Clause 5. The method of any one of clauses 1 to 4, wherein the forming of the circuit layer further comprises placing an inorganic layer on the preliminary base layer, and the pad electrode is disposed on the inorganic layer.
Clause 6. The method of claim 5, wherein the forming of the base layer further comprises:
   etching the preliminary base layer to form the first opening; and
   etching the inorganic layer to form a second opening through which the pad electrode is exposed to the outside to correspond to the first opening.
Clause 7. The method of clause 6, wherein the second opening is substantially simultaneously formed with the first opening.
Clause 8. The method of clause 6 or clause 7, wherein the forming of the circuit layer further comprises:
   forming a metal layer on the inorganic layer; and
   etching the metal layer to form the pad electrode.
Clause 9. The method of clause 8, wherein the forming of the circuit layer further comprises:
   forming a shielding electrode; and
   forming a transistor comprising a semiconductor pattern on the shielding electrode, and the semiconductor pattern overlaps the shielding electrode.
Clause 10. The method of clause 9, wherein the pad electrode is substantially simultaneously formed with the shielding electrode of the transistor.
Clause 11. The method of clause 9, wherein the forming of the circuit layer further comprises forming a gate electrode overlapping the semiconductor pattern, and the pad electrode is substantially simultaneously formed with the gate electrode.
Clause 12. The method of clause 11, wherein the forming of the circuit layer further comprises forming a connection pattern connected to the semiconductor pattern, and the pad electrode is substantially simultaneously formed with the connection pattern.
Clause 13. The method of any one of clauses 1 to 12, further comprising forming an adhesive resin of which at least a portion is disposed in the first opening after the forming of the metal pattern, and the adhesive resin covers the metal pattern.

## Claims

1. A display device comprising:
a display panel displaying an image;
a circuit board coupled with the display panel; and
a metal pattern electrically connecting the display panel and the circuit board, wherein the display panel comprises:
a base layer; and
a circuit layer disposed on the base layer and comprising a pad electrode exposed to an outside via a first opening defined through the base layer, wherein the metal pattern comprises:
a first portion overlapping the first opening and being in contact with the pad electrode; and
a second portion that does not overlap the first opening and is in contact with the circuit board.

2. The display device of claim 1, wherein the pad electrode comprises:
a first pad portion that is disposed on the base layer and that does not overlap the first opening; and
a second pad portion overlapping the first opening.

3. The display device of claim 2, wherein the base layer comprises:
a sub-base layer that is in contact with the circuit board; and
a base inorganic layer disposed on the sub-base layer.

4. The display device of claim 3, wherein the first opening comprises:
a first sub-opening defined through the base inorganic layer; and
a second sub-opening defined through the sub-base layer.

5. The display device of claim 4, wherein the second pad portion is disposed in the first sub-opening, and the second pad portion is exposed to the outside via the second sub-opening.

6. The display device of any one of claims 2 to 5, wherein the circuit layer comprises an inorganic layer disposed on the base layer, the pad electrode is disposed on the inorganic layer, and the inorganic layer comprises a second opening through which the pad electrode is exposed to correspond to the first opening.

7. The display device of claim 6, wherein the circuit layer comprises:
a transistor;
at least one signal line connected to the transistor; and
a shielding electrode disposed under the transistor and overlapping a semiconductor pattern of the transistor.

8. The display device of claim 7, wherein the first pad portion and the shielding electrode are disposed on a same layer.

9. The display device of claim 7, wherein the circuit layer further comprises a connection pattern connected to the semiconductor pattern, wherein the first pad portion and the connection pattern are disposed on a same layer.

10. The display device of claim 7, wherein the transistor further comprises a gate electrode overlapping the semiconductor pattern, wherein the first pad portion and the gate electrode are disposed on a same layer.

11. The display device of any one of claims 7 to 10, wherein the circuit layer further comprises at least one signal line connected to the transistor, wherein the pad electrode is electrically connected to the signal line.

12. The display device of any one of claims 1 to 11, wherein the first portion is disposed in the first opening.

13. The display device of claim 12, wherein the first portion covers one side surface of the base layer that defines the first opening.

14. The display device of claim 13, further comprising an adhesive resin of which at least a portion is disposed in the first opening, wherein the adhesive resin covers the metal pattern.

15. The display device of claim 14, wherein the adhesive resin covers a other side surface of the base layer, which faces the one side surface of the base layer.
